(19) Europäisches Patentamt / European Patent Office / Office européen des brevets

(11) **EP 4 633 043 B1**

(12) **EUROPEAN PATENT SPECIFICATION**

(45) Date of publication and mention
of the grant of the patent:
**13.05.2026 Bulletin 2026/20**

(51) International Patent Classification (IPC):
***H03M 7/30*** *(2006.01)*     ***H03M 7/42*** *(2006.01)*
***H03M 7/40*** *(2006.01)*

(21) Application number: **25169207.5**

(22) Date of filing: **08.04.2025**

(52) Cooperative Patent Classification (CPC):
**H03M 7/607; H03M 7/40**

(54) **CODING METHODS AND SYSTEMS**

KODIERUNGSVERFAHREN UND -SYSTEME

PROCÉDÉS ET SYSTÈMES DE CODAGE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **08.04.2024 AU 2024900972**

(43) Date of publication of application:
**15.10.2025 Bulletin 2025/42**

(73) Proprietor: **Blackmagic Design Pty Ltd
South Melbourne, Victoria 3205 (AU)**

(72) Inventor: **ECOB, Stephen Edward
South Melbourne, 3205 (AU)**

(74) Representative: **Mathys & Squire
32 London Bridge Street
The Shard
London SE1 9SG (GB)**

(56) References cited:

- ADE KULDIP K ET AL: "ROI based near lossless hybrid image compression technique", IEEE INTERNATIONAL CONFERENCE ON ELECTRICAL, COMPUTER AND COMMUNICATION TECHNOLOGIES (ICECCT), 2015, 5-7 MARCH 2015, COIMBATORE, IEEE, 5 March 2015 (2015-03-05), pages 1 - 5, XP033210325, ISBN: 978-1-4799-6084-2, [retrieved on 20150826], DOI: 10.1109/ICECCT.2015.7226121
- JAYANT N S: "ADAPTIVE QUANTIZATION WITH A ONE-WORD MEMORY", BELL SYSTEM TECHNICAL JOURNAL, AT AND T, SHORT HILLS, NY, US, vol. 52, no. 7, 1 September 1973 (1973-09-01), pages 1119 - 1144, XP001080572, ISSN: 0005-8580
- ANONYMOUS: "Blackmagic IP10", 1 June 2024 (2024-06-01), pages 1 - 9, XP093292167, Retrieved from the Internet <URL:https://downloads.blackmagicdesign.com/Developer/Converters/20240613-76d445/Blackmagic_IP10_Codec_v1.1.zip>

**Description**

**Field**

The present disclosure relates to methods of encoding a data sequence to compress it, and methods of decoding such an encoded data sequence, as well as systems for encoding data and/or decoding data using such methods. Embodiments will generally be described in connection with encoding sequences of data representing video or audio, but the present invention should not be considered to be limited to such applications.

**Background**

There are a great number of different codecs available for encoding and/or decoding sequences of data such as video or audio data, but occasionally a particular set of requirements emerge that are not well catered to by an existing codec. One such set of requirements is the need for relatively low compression that is preferably able to be performed with simple hardware. The article from Kuldip K. Ade et al "ROI based near lossless hybrid image compression technique", ICECCT, 2015, XP033210325, discloses an hybrid image compression method which proposes lossless compression for a region of interest and near lossless compression for the rest of an image.

This niche is addressed by codecs such as PNG, T81 lossless JPEG and T87 JPEG-LS, which each provide light compression with a small hardware size. All three achieve the small hardware size by using a pixel prediction algorithm, where a given pixel is transmitted as the difference of the pixel from a neighbouring pixel (or a value derived from a combination of multiple neighbouring pixels).

These codecs utilise variable length codes (VLC). Variable length codes achieve data compression by using short codes for frequently transmitted differences and longer codes for infrequently transmitted differences. Although encoded data from such codecs is generally smaller than the source data, most source data (e.g. images) produce short bursts of encoded data that is larger than the source data. This necessitates the use of VLC data buffers such as FIFOs, which add to the hardware resource requirements and thus increase hardware cost.

The present inventor has identified that it would be desirable to further simplify hardware requirements or at least provide an alternative to such codecs.

The systems, devices, methods and approaches described in this section, and components thereof are known to the inventor. Therefore, unless otherwise indicated, it should not be assumed that any of such systems, devices, methods, approaches or their components described are citable as prior art merely by virtue of their inclusion in this section, or that such systems, devices, methods, approaches and components would ordinarily be known to a person of ordinary skill in the art.

**Summary**

Aspects and embodiments of the present invention are set out in the appended claims. These and other aspects and embodiments of the invention are also described herein.

Disclosed herein are methods of transforming an nth symbol of a first data sequence into an mth symbol of a second data sequence. Also disclosed is a method of decoding an mth symbol of a second data sequence having a second data type and being created by encoding the nth symbol of a first data sequence having a first data type, said decoding generating an output symbol having said first data type. There is also disclosed encoding and decoding devices. For example, the encoding device comprises an input on which a first data sequence is received, an output on which a second data sequence is transmitted and a processing system configured to process received symbols of the first data sequence in series and output symbols of the second data sequence.

In a first aspect of the present disclosure there is provided a computer-implemented method for compressing data involving transforming an nth symbol of a first data sequence into an mth symbol of a second data sequence, the computer-implemented method comprising: receiving the nth symbol of the first data sequence; generating the mth symbol of the second data sequence from the nth symbol of the first data sequence using a transformation belonging to a predetermined set of transformations mapping a first data type comprising a library of first symbols having a first code length to a second data type comprising a library of second symbols having a second code length that is shorter than said first code length; said predetermined set of transformations comprising a plurality of subsets of transformations, wherein each subset of transformations map the first data type to the second data type, and include a group of lossless transformations that losslessly map certain symbols of the first data type to symbols of the second data type, and at least one group of lossy transformations between remaining symbols of the first data type and the second data type; wherein said transformation used to generate the mth symbol of the second data sequence from the nth symbol of the first data sequence is a member of a subset of transformations in which an n-1th symbol of the first data sequence is amongst the certain symbols that are losslessly mapped to a second symbol in said subset's group of lossless transformations.

In some embodiments in each subset of transformations the certain symbols of the first data type that are losslessly mapped to symbols of the second data type, represent a contiguous group of data values.

In some embodiments in each subset of transformations the, or each, group of remaining symbols of the first data type that are transformed with a lossy transformation into said the second data type represent a contiguous group of data values.

In some embodiments in each subset of transformations the second data type comprises a first number of symbols to which said certain symbols of the first data type are mapped losslessly and a second number of symbols to which the other symbols of the first data type are mapped lossily, wherein the first number of symbols and second number of symbols in the library of the second data are equal.

In some embodiments the method further includes, determining a next subset of transformations, for use in transforming the n+1th symbol of the first sequence of data, based on the nth symbol of the first data sequence; and transforming the n+1th symbol of the first sequence of data into the m+1th symbol of the second data sequence using a transformation from the next subset of transformations.

In some embodiments in the next subset of transformations the nth symbol is losslessly mapped to a symbol of the second data type.

In some embodiments the method further includes performing an inverse transformation of the mth symbol of the second sequence of data into the first data type using an inverse transformation that corresponds to a transformation in the same subset of transformations used to generate the mth symbol of the second sequence.

Also disclosed is a computer-implemented method of encoding a first data sequence coded in a first data type having codewords of a first length into a second data sequence coded in a second data type having codewords of a second length; said method including: determining a fixed set of transformations that map symbols of the first data type to symbols of the second data type, said fixed set of transformations including lossless mappings between symbols of each data type and lossy mappings between symbols of each data type, receiving the nth symbol of the first data sequence; determining a transformation from the fixed set of transformations to be used to encode said nth symbol, wherein the determined transformation is lossless if the nth symbol of the first data sequence is the same as the n-1th symbol or within a predetermined difference threshold of the n-1th symbol.

The fixed set of transformations that map symbols of the first data type to symbols of the second data type may comprise a plurality of subsets of transformations, wherein each subset of transformations map all symbols of the first data type to the second data type and include a group of lossless transformations that losslessly map certain symbols of the first data type to symbols of the second data type, and at least one group of lossy transformations between remaining symbols of the first data type and the second data type.

The determined transformation may be used to encode said nth symbol, is a member of a subset of transformations in which the n-1th symbol and nth symbol both correspond to certain symbols in the group of lossless transformations of said subset of transformations.

In a second aspect of the present disclosure there is provided a computer-implemented method for decompressing data involving decoding an mth symbol of a second data sequence having a second data type comprising a library of second symbols having a second code length that was created by encoding the nth symbol of a first data sequence having a first data type comprising a library of first symbols having a first code length, wherein the second code length is shorter than the first code length, said decoding generating an output symbol having said first data type, the computer-implemented method comprising: receiving the mth symbol of the second data sequence; generating the output symbol using a transformation belonging to a predetermined set of transformations mapping the second data type to the first data type; said predetermined set of transformations comprising a plurality of subsets of transformations, wherein each subset of transformations map the second data type to the first data type; and wherein said transformation used to generate the output symbol is a member of a subset of transformations selected on the basis of an output symbol corresponding to the m-1th symbol.

In some embodiments each subset of predetermined set of transformations correspond to a subset of predetermined transformations that are able to be used during encoding the second data sequence.

In some embodiments each subset of predetermined set of transformations include: a group of transformations which are the direct reverses of a corresponding group of lossless transformations that may be used to encode the first data sequence into the second data sequence, and a plurality of remaining transformations that correspond to a plurality of groups of lossy transformations between the first data type and second data type that may be used to encode the first data sequence into the second data sequence.

In some embodiments the method further includes setting a predetermined subset of transformations mapping the second data type to the first data type for use in decoding the m+1th symbol of the second data sequence.

Also disclosed is a method of transforming an nth symbol of a first data sequence into an mth symbol of a second data sequence comprising: receiving the nth symbol of the first data sequence; generating the mth symbol of the second data sequence from the nth symbol of the first data sequence using a transformation belonging to a predetermined set of transformations mapping a first data type comprising a library of first symbols having a first code length to a second data type comprising a library of second symbols having a second code length that is different to said first code length; said predetermined set of transformations comprising a plurality of subsets of transformations, wherein each subset of transformations map the first data type to the second data type, and a group of lossless transformations that losslessly map certain symbols of the first data type to symbols of the second data type, and at least one group of lossy transformations between remaining symbols of the first data type and the second data type; wherein said transformation used to generate the mth symbol is chosen on the basis of the n-1th symbol of the first data sequence.

Also disclosed is a method of encoding a first data sequence coded in a first data type having codewords of a first length into a second data sequence coded in a second data type having codewords of a second length; said method including: determining a fixed set of transformations that map symbols of the first data type to symbols of the second data type, said fixed set of transformations including lossless mappings between at least some symbols of each data type, and lossy mappings between at least some symbols of each data type; receiving the nth symbol of the first data sequence; determining a transformation from the fixed set of transformations to be used to encode said nth symbol based on the n-1th symbol of the first data sequence.

In a third aspect of the present disclosure there is provided an encoding device comprising: an input on which a first data sequence is received; said first data sequence comprising a first data symbols of a first data type and having a first code length, an output on which a second data sequence is transmitted; said second data sequence comprising a second data symbols of a second data type and having a second code length that is different to said first code length; a processing system configured to process received symbols of the first data sequence in series and output symbols of the second data sequence; wherein the processing system is configured to perform a method of the first aspect.

In fourth aspect of the present disclosure there is provided a decoding device comprising: an input on which a second data sequence is received; said second data sequence comprising a second data symbols of a second data type and having a second code length, an output on which output symbols are transmitted, said output symbols having a first data type corresponding to a first data type of a first data sequence that was encoded to form the second data sequence; a processing system configured to process received symbols of the second data sequence in series and output symbols of the third data sequence with the same data type as the first data sequence; wherein the processing system is configured to perform a method of the second aspect.

Also disclosed is an encoding device according to the fourth aspect which is further adapted to perform the method of the second aspect.

While the invention(s) disclosed herein are amenable to various modifications and alternative forms, specific embodiments are shown by way of example in the drawings and are described in detail. It should be understood, however, that the drawings and detailed description are not intended to limit the invention(s) to the particular form disclosed.

The disclosure also provides computer programs and computer program products comprising software code adapted, when executed on a data processing apparatus, to perform any of the methods and/or for embodying any of the apparatus and system features described herein, including any or all of the component steps of any method.

The disclosure also provides a computer or computing system (including networked or distributed systems) having an operating system which supports a computer program for carrying out any of the methods described herein and/or for embodying any of the apparatus or system features described herein.

The disclosure also provides a computer readable media having stored thereon any one or more of the computer programs aforesaid.

The disclosure extends to methods, system and apparatus substantially as herein described and/or as illustrated with reference to the accompanying figures.

The disclosure also provides a signal embodying a computer program or a computer program product for carrying out any of the methods described herein, and/or for embodying any of the apparatus features described herein, a method of transmitting such a signal, and a computer product having an operating system which supports a computer program for carrying out the methods described herein and/or for embodying any of the apparatus features described herein.

Any feature in one aspect of the disclosure may be applied to other aspects of the invention, in any appropriate combination. In particular, method aspects may be applied to apparatus aspects, and vice versa. As used herein, means plus function features may be expressed alternatively in terms of their corresponding structure, such as a suitably programmed processor and associated memory.

Furthermore, features implanted in hardware may generally be implemented in software, and vice versa. Any reference to software and hardware features herein should be construed accordingly.

It should also be appreciated that particular combinations of the various features described and defined in any aspects of the disclosure can be implemented and/or supplied and/or used independently.

**Brief description of the Drawings**

Fig. 1 illustrates a system in which an encoding method according to an embodiment of the present disclosure may be implemented.

Fig. 2 (2A in greyscale) illustrates a set of predetermined transformations usable for encoding and decoding in one embodiment.

Fig. 3 (3A in greyscale) illustrates schematically a set of predetermined transformations usable for encoding and decoding in another embodiment.

Fig. 4A is a flowchart illustrating a process for encoding according to an embodiment of the present disclosure.

Fig. 4B is a flowchart illustrating a process for encoding according to an embodiment of the present disclosure.

Fig. 5A is a flowchart illustrating a process for decoding according to an embodiment of the present disclosure.

Fig. 5B is a flowchart illustrating a process for decoding according to an embodiment of the present disclosure.

Fig. 6 is a flowchart that describes a "Next Table" process of an embodiment.

Fig. 7 is a flowchart that describes an "Encode Sample" process of an embodiment.

Fig. 8 is a flowchart that describes a "Decode Sample" process of an embodiment.

Fig. 9 is a flowchart that describes an "Encode Sequence" process of an embodiment.

Fig. 10 is a flowchart that describes a "Decode Sequence" process of an embodiment.

Fig. 11 is a schematic block diagram of an encoder that may implement an embodiment.

Fig. 12 is a schematic block diagram of a decoder that may implement an embodiment.

Fig. 13 is a circuit diagram that shows a circuit that may perform the "Decode Sample" method of Fig. 8.

Figures 14A and 15A show examples of single images compressed using embodiments of the present disclosure;

Figures 14B and 15B illustrate lossy pixels in the images of figures 14A and 15A respectively.

## Detailed description

In the following description numerous specific details are set forth in order to provide a thorough understanding of the present invention. It will be apparent, however, that the present invention may be practiced without these specific details. In some instances, well-known structures and devices are shown in block diagram form in order to avoid unnecessary obfuscation of salient details.

Embodiments of the present disclosure can be applied to any digital data that consists of a sequence of fixed size codewords that need to be stored or transmitted with some compression, for example this includes one dimensional digital data like a sequence of sound samples, two dimensional digital data like a sequence of data representing a bitmap image, or three dimensional data like a video clip, but the disclosure should not be considered to be limited to such examples.

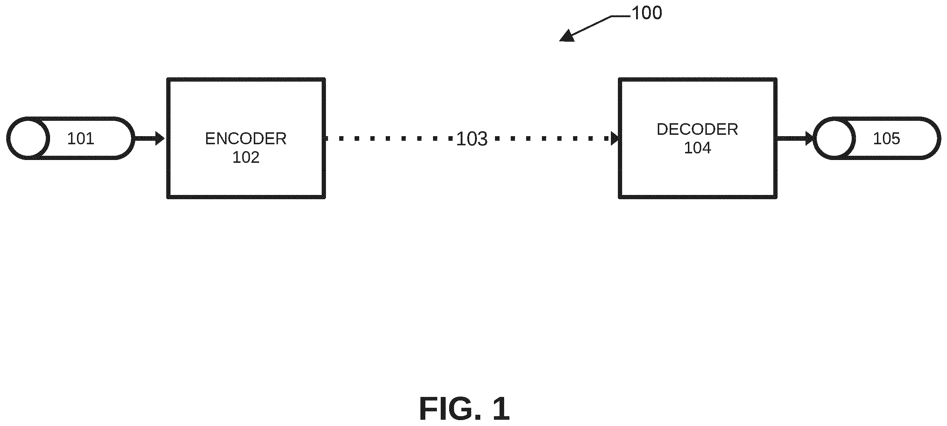

Fig. 1 illustrates a system in which an encoding method according to an embodiment of the present disclosure may be implemented. The system 100 includes an input channel 101, being a wired or wireless communications channel or bus on which a first data sequence is received at an encoder 102. The encoder 102 may be a stand-alone encoder device, such as a format converter adapted to receive a data sequence in one format and convert it to a second format or compress the data sequence, such as the Blackmagic 2110 IP Converter from Blackmagic Design Pty Ltd. Alternatively the encoder 102 may form a component, subsystem or function of a device with additional functionality and purposes, such as a personal computer, computer server, network storage device, media processing appliance; network switch to name a few examples.

The encoder 102 is configured to receive the first data sequence, which is encoded in a first data type. The first data type comprises a library of first symbols having a first code length. The encoder 102 is arranged to convert (or encode) each symbol of the first data sequence into data of a second data type to thereby generate a second data sequence. The second data type comprises a library of second symbols that have a second code length. The second code length is different to the first code length and when the encoder 102 is being used for compression (also termed "encoding") the second code length is shorter than the first code length.

The second data sequence is output, directly or indirectly, from the encoder 102 on an output channel 103. The output channel 103 can be a wired or wireless communications channel or bus. The output channel 103 may connect to any applicable external device, such as a data storage system to store the second data sequence or an external device that decodes the second data sequence for downstream use, or uses the second data sequence in the encoded form for a downstream purpose. The output channel 103 may comprise, or be connected to, or form part of a network such as LAN, WAN, VPN, a public network such as the internet or the like, possibly via one or more intervening networks or devices.

In use the encoder 102 performs a transformation on each of the symbols of the first data sequence that it receives. The transformation performed on each symbol (for example the nth symbol of the first data sequence) is one of a set of transformations that map the first data type to the second data type. These transformations may be predetermined. The set of transformations is determined by the relative code lengths of the first data type and second data type.

The set of transformations can be considered to include a plurality of subsets of transformations, each of which defines a different mapping of the symbols of the first data type to the second data type. All such subsets of transformations includes both lossless and lossy transformations between the first and second data types. In each subset of transformations there are a group of certain symbols in the first data type that are losslessly mapped to symbols in the second data type. The remaining symbols in the first data type have a lossy mapping to the second data type. That is, more than one of the remaining symbols in the first data type map to the same symbol in the second data type. The certain symbols within the group of lossless transformations of a subset of transformations may represent a corresponding group of contiguous values within the data represented by the first data sequence. So symbols representing a group of values are losslessly encoded, but outside that group the remaining values are lossily encoded. Which group of symbols of the first data type are losslessly transformed in each subset of transformations differs from subset to subset, such that there is always at least one subset of transformations in which a given symbol of the first data type will be losslessly mapped to a symbol of the second data type.

For each symbol to be encoded it is necessary to determine which transformation must be used. Generally speaking, in embodiments of the present disclosure, this will depend on the previous data symbol (n-1th symbol) that was received prior to the current symbol (nth symbol) to be encoded. In this regard the previous data symbol (n-1th symbol) will be used to determine which subset of transformations in the set of transformations will contain the required transformation for the nth data symbol.

In order to maximise accuracy when decoding, it may be advantageous to determine an expected decoded value for the (encoded) n-1th symbol and to base the determination of the subset of transformations to be used for encoding the nth data symbol on this expected decoded value. This takes into account that the decoder will not directly know the n-1th symbol only it's decoded value (called the " n*-1th " symbol herein). If the n-1th symbol of the first data sequence is losslessly encoded, the m-1th symbol of the second data sequence will decode back to the n-1th symbol, but if it was lossily encoded its decoding may not identically replicate the n-1th symbol. Thus using an expected decoded value instead of the n-1th value directly lets both the decoder and encoder use the same subset of transformations for both decoding and encoding. For example after the n-1th symbol of the first data sequence is encoded it becomes the m-1th data symbol of the second data sequence. This m-1th data symbol may also be decoded (e.g. at the encoder) in order to determine the expected decoded value that the decoder will produce from the m-1th symbol. This expected decoded value can then be used as the basis for the selection of the transformation used to encode the nth symbol.

Returning to Fig. 1, from the point of view of a decoder 104 the channel 103 becomes an input channel. The decoder 104 is configured to receive the second data sequence, which is encoded in the second data type. The decoder 104 is arranged to convert (or decode) each symbol of the second data sequence back into data of the first data type to thereby generate a third data sequence such that the mth symbol of the second data sequence is decoded into the n*th symbol of the third data sequence. As with the encoder 102, the decoder 104 may be a stand-alone decoder device, such as a format converter adapted to receive a data sequence in one format and convert it to a second format or decompress the data sequence, such as the Blackmagic 2110 IP Converter from Blackmagic Design Pty Ltd. Alternatively the decoder 104 may form a component, subsystem or function of a device with additional functionality and purposes, such as a personal computer, computer server, network storage device, network switch to name a few examples.

Decoding is performed in a similar fashion to encoding. The mth symbol of the second data sequence is decoded into the n*th symbol of the third data sequence according to a one of a set of predetermined transformations mapping the second data type back to the first data type. That is the predetermined set of transformations used for encoding can additionally have corresponding inverse transformations that are used for decoding. The set of decoding transformations are also arranged in the same subsets of transformations as those used for encoding. Moreover within each subset of transformations, the decoding transformations for the group of lossless mappings used during encoding, may simply be a direct inversion of the mappings used for encoding. For the remaining inverse transformations in each subset of transformations, which correspond to the remaining lossy transformations used during encoding, the inverse (i.e.

decoding) transformation maps each symbol in the second data type to one of the symbols of the first data type that was mapped to it by the encoding transformation. In some embodiments the inverse (i.e. decoding) transformation maps a symbol in the second data type to a symbol in the first data type that corresponds to a central value amongst the symbols within the group of lossy transformations that were mapped by the encoding transformation to the symbol of the second data type. This selection minimises the maximum error in decoding values that had been lossily encoded, the maximum error being half of the spread of values represented by the symbols in the first data type that were subject to a lossy transformation to the same symbol of the second data type.

Each subset of transformations may include a unique mapping between the first and second data types, when both encoding and decoding, compared to each other subset of transformations.

As noted above the decoder 104 is arranged to convert (or decode) each symbol of the second data sequence back into data of the first data type to thereby generate a third data sequence. The decoding proceeds as per the encoding process insofar as the decoder must determine the transformation that needs to be used to decode the mth symbol of the second data sequence. The transformation will be a member of the same subset of transformations that were used to encode the nth data symbol into the mth data symbol.

In practice the correct subset of transformations may be determined on the basis of the value of the previous data symbol (the m-1th symbol). In particular it is dependent on the decoded value (n-1*th symbol) of the symbol received (m-1th) prior to symbol to be decoded (mth symbol).

Decoded values produced by 104 are output, directly or indirectly, to 105, an output channel. 105 is a wired or wireless communications channel or bus on which a third data sequence is output by decoder 104.

Once the subset of transformations is determined, the correct transformation based on the value of the mth symbol can be applied to generate the n*th data symbol of the third data sequence.

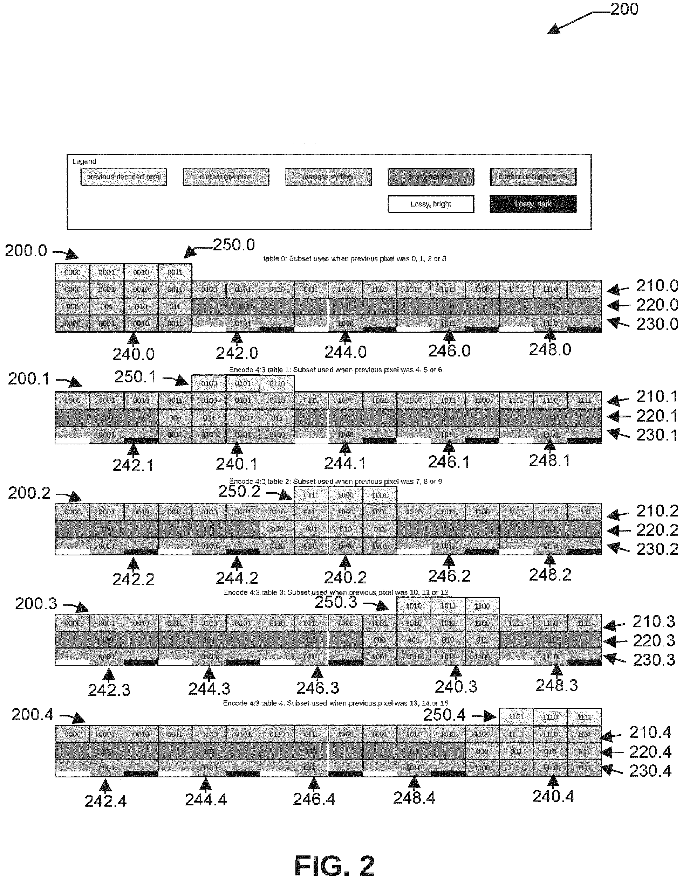

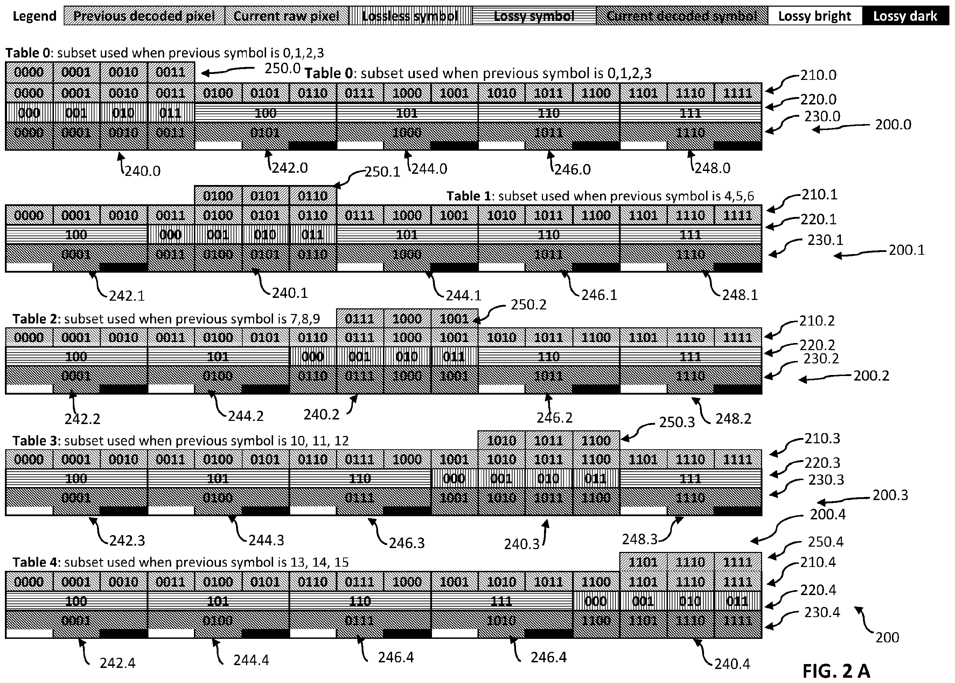

Details of an exemplary code table defining the set of transformations able to be used in an embodiment of the present disclosure in which a first data sequence encoded in a first data type with 4 bit codewords are compressed into a second data sequence encoded in a second data type with 3 bit codewords are shown in Fig. 2.

Fig. 2 (2A) illustrates one way in which a first data type, comprising 4 bit symbols can be mapped to a second data type comprising 3 bit symbols in one embodiment. The library of 4 bit symbols in the first data type comprises the 16 symbol values from 0000 to 1111 and are indicated in green boxes (in Fig. 2A, by the shaded boxes with light diagonal lines downwards to the right) in the code tables. The library of 3 bit symbols in the second data type comprises the 8 symbol values from 000 to 111 and are indicated in blue and red boxes (in Fig. 2A, by the shaded boxes with vertical lines and by the shaded boxes with horizontal lines) in the code tables.

In Fig. 2 (2A) the five code tables, Table 0 to Table 4 together comprise a predetermined set of transformations that may be used in the encoding and decoding process. Each table (Table 0 to Table 4) comprises a subset of the predetermined transformations. As can be seen by inspection of the table, each table defines a full mapping of the library of the first data type to the second data type, and each mapping is unique. That is, no two subsets of transformation (code tables) are the same.

Each table (Table 0 to Table 4) is arranged as follows:

a) the first full row of symbols 210.0 ... 210.4 represent the codewords of the first data type;

b) the second full row of symbols 220.0 ... 220.4 represent the codewords of the second data type;

c) the third full row of symbols 230.0 ... 230.4 represent those codewords of the first data type resulting from decoding.

The code tables (tables 0 to table 4) represent a look-up table to allow encoding of any received symbol of the first data type. When a symbol of the first data type is received its transformation is determined by finding it in the top row 210.0 ... 210.4 of a code table 0 to 4 and reading off the corresponding value directly below it in the second full row 220.0 ... 220.4 of the code table to find its encoded value in the second data type. Decoding is similar, when a symbol of the second data type is received its transformation is determined by finding it in the second row 220.0 ... 220.4 of a code table 0 to 4 and reading off the corresponding value directly below it in the third full row 230.0 ... 230.4 of the code table to find its decoded value, which is again in the first data type.

Each code table (tables 0 to table 4) includes a group 240.0 ... 240.4 of symbols in the first data type that are losslessly mapped to the second data type. The remaining symbols of the first data type are lossily mapped to symbols of the second data type. These may be arranged into groups (e.g. 242.0, 244.0, 246.0, 228.0 in code table 0) of lossy transformations that map between a group of remaining data symbols in the first data type to the same symbol of the second data type (e.g. all symbol of the first data type in group 242.0 of table 0 map to the symbol 100 in the second data type, all symbols of the first data type in group 244.0 of table 0 map to the symbol 101 in the second data type, all symbols of the first data type in group 246.0 of table 0 map to the symbol 110 in the second data type, all symbols of the first data type in group 248.0 of table 0 map to the symbol 111 in the second data type. Similar groups are labelled in the other subsets' of transformations code tables). Fig. 2 (2A) also includes a legend explaining the colours (in 2A, shading and fill) of the various symbols/groups of symbols used in Fig. 2 (2A) and 3 (3A). Yellow boxes (shaded boxes with light diagonal lines upwards to the right) represent the previous decoded symbol (n*-1th symbol), green boxes (shaded boxes with light diagonal lines downwards to the right) represent the current symbol of the first data sequence (nth symbol) represented in the first data type; blue boxes (shaded boxes with vertical lines) represent the current symbol (mth) represented in the second data type encoded into the second data sequence using a lossless transformations from the first data type; red boxes (shaded boxes with horizontal lines) represent the current symbol (mth) represented in the second data type encoded into the second data sequence using a lossy transformation from the first data type; purple boxes (shaded boxes with heavy shaded diagonal lines downwards to the right) represent the decoded current symbol (n*th) represented in the first data type decoded into the third data sequence. White or black bars under a portion of a purple decoding symbol box (shaded box with heavy shaded diagonal lines downwards to the right) represents whether, in the case that the data being encoded represents a pixel illumination value, the decoded current symbol (n*th) will be brighter (white bar) than the original symbol value, or darker (black bar) than the original symbol value.

For decoding, each symbol of the second data type are transformed to the corresponding symbol in the first data type that are listed in the bottom row 230.0, 230.1, 230.2, 230.3, 230.4 of the code tables. As can be seen, in each code table the group of lossless transformations 240.0 ... 240.4 are mapped back to their original values in the first data type. In each transformation table, the remaining symbols (coloured red or indicated by the shaded boxes with horizontal lines) of the second data type are mapped to a symbol of the first data type in the bottom row 230.0, 230.1, 230.2, 230.3, 230.4 (coloured purple or indicated by the heavy shaded boxes with diagonal lines downwards to the right). The mapping is such that the codeword from the first data type in the bottom row 230.0, 230.1, 230.2, 230.3, 230.4 (coloured purple or indicated by the heavy shaded boxes with diagonal lines downwards to the right) that matches the codeword of the second data type, is the codeword corresponding to the central value of the group of codewords that were mapped to the second data type during encoding. So taking table 1 as an example, during encoding, codewords 0000, 0001, 0010 are arranged in a group 242.1 that are all lossily mapped to codeword 100 in the second data type. For decoding, the symbol 100 in the second data type must be mapped one of codewords 0000, 0001, 0010 in the group 242.1. In embodiments of the present disclosure, the mapping is chosen such that the central value amongst the first data type values in group 242.1 is used, thus 100 in the second data type is decoded to 0001 in the first data type. This selection minimises the maximum error that is introduced by the lossy encoding. In this example the maximum error is only one codeword. This is illustrated in the Fig. 2 (2A) with bars below the symbol values in the bottom row 230.0, 230.1, 230.2, 230.3, 230.4 of the code tables. A black bar indicates that the decoded value of a lossily encoded symbol will, in the case of the data being encoded representing the brightness of a pixel, be darker than the original value, whereas a white bar indicates that the decoded value of a lossily encoded symbol will be lighter than the original value in the case that the data being encoded represents the brightness of a pixel. A purple bar (or bar having heavy shading with diagonal lines downwards to the right) indicates no change of value as the lossy decoding process fortuitously reproduces the exact input value, so is lossless by good fortune.

The code tables of Fig. 2 (2A) illustrate an advantageous property of the predetermined set of transformations that may be employed in some embodiments, namely that because there are equal numbers of lossy and lossless transformations in each subset of transformations, a single bit of the encoded symbol (i.e. the symbols of the second data type) can operate as a flag to divide the codewords in the second data types into lossy and lossless values (that is values that result from a lossy or lossless transformation). In the illustrative embodiments the first bit of the encoded symbol value can be used during decoding to determine if the symbol is a lossy or lossless symbol. In this case if the first bit of an encoded symbol is 1 the transformation was lossy, whereas if it is 0 the transformation was lossless. Use of a single bit as a "lossy flag" in this manner can make decoding computationally more straightforward, but in some embodiments may not need to performed.

In the foregoing description of Fig. 2 (2A), it will be noted that for any symbol of the first data sequence that is received there are 5 possible transformations that could apply to it because it could be encoded according to any of the five code tables. Thus there is a need to determine which of the subsets of transformations (i.e. which code table 200.0, 200.1, 200.2, 200.3, 200.4) should be used to transform any given symbol in the first data sequence.

As noted above, generally speaking the selection of which subset of transformations to use will depend on the data symbol that was received before the current symbol in the first data sequence. As discussed below this dependency is based not on the symbol directly but on the decoded value corresponding to it. This is illustrated graphically in Fig. 2 with the partial row 250.0, 250.1, 250.2, 250.3, 250.4 of symbols (coloured yellow or shaded boxes with light diagonal lines upwards to the right) in the topmost row of each code table code table 200.0, 200.1, 200.2, 200.3, 200.4.

If the previous symbol corresponded to one of the values in the partial rows 250.0 the transformations defined in code table 200.0 will be used for encoding and decoding the current symbol, whereas if the previous symbol corresponded to one of the values in the partial rows 250.1 the transformations defined in code table 200.1 will be used for encoding and decoding the current symbol, and so on to code table 200.4.

To maximise accuracy when decoding, it is not the original value of the previous symbol that is used for determination of the subset of transformations to be used with the current pixel, but the expected decoded value of the previous symbol, because the decoder will not directly know the original symbol value only it's decoded value. It should be noted at the encoder, that the code table representing the subset of the predetermined set of transformations that are used for encoding the next data symbol is determined from the expected decoded value of the current symbol. To know what the expected decoded value is the encoder may simply decode the encoded value of the previous symbol.

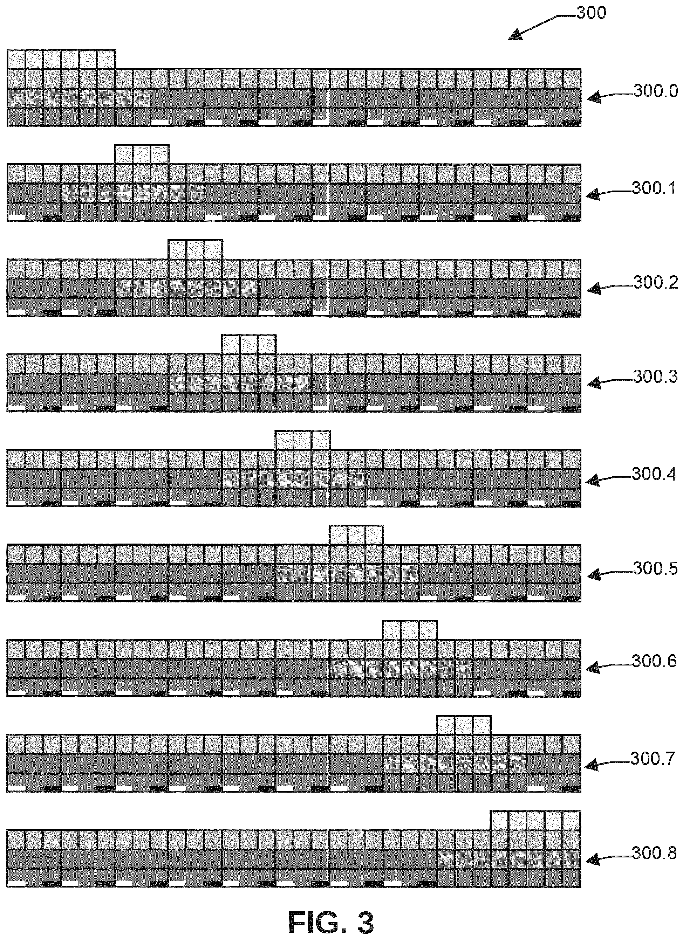

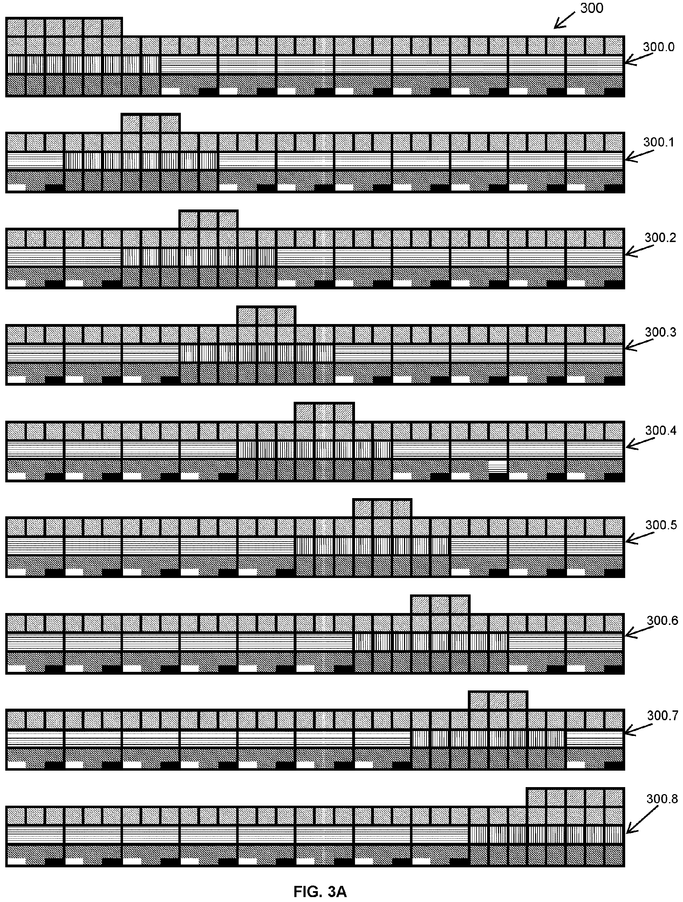

Fig. 3 (3A) illustrates schematically a set 300 of predetermined transformations that may be used in an embodiment where the first data type is a 5 bit binary value and the second data type is a 4 bit binary value, hence the encoding has a compression ratio of 5:4. The set of predetermined transformations is grouped into subsets 300.0, 300.1, 300.2, 300.3, 300.4, 300.5, 300.6, 300.7, 300.8 each of which is expressed diagrammatically in its own code table. Each code table is different to each other. In each code table the values (boxes) in green (or represented by the shaded boxes with light diagonal lines downwards to the right) each represent a first data type code value ranging from 00000 to 11111 from left to right. The second row represents 4 bit data values of the second data type from 0000 to 1111. Boxes in blue (or shaded boxes with vertical lines) represent values that are losslessly mapped from the first data type and boxes in red (or shaded boxes with horizontal lines) represent values that are lossily mapped from the first data type. The specific values of the mapping are up to the specific implementation chosen, but in this exemplary case the blue boxes (or shaded boxes with vertical lines) represent a contiguous group of values in the second data type ranging from 0000 to 0111 from left to right to which values of the first data type are losslessly mapped, and the red boxes (or shaded boxes with horizontal lines) represent a range of values in the second data type from 1000 to 1111 from left to right in all code tables to which groups of the remaining values of the first data type are lossily mapped. As can be seen the lossy transformations take a group of three remaining data values of the first data type and map them to a single value in the second data type. The bottom row is the corresponding decoded value expressed in the first data type. The group of losslessly transformed values are mapped back to the same value in the first data type as originally received. The lossily transformed values are each mapped back to the first data type using the central value of their respective group of values. Which subset of the predetermined transformations is to be used to encode a specific symbol (the nth symbol) of the first data sequence is determined by reference to the yellow boxes (or shaded boxes with light diagonal lines upwards to the right). After the previous symbol (n-1th) has been encoded the encoder determines its expected decoded value (n-1*th symbol), e.g. by decoding it), then the code table in which the n-1*th value corresponds to a yellow box (or shaded box with light diagonal lines upwards to the right) is used to encode the nth symbol. The same code table is used by the decoder to decode the mth symbol. e.g. if the n-1*th symbol is 01100, 01101 or 01110 code table 3, (300.3) would be used to encode the nth symbol, or if the n-1*th symbol is 11011, 11100, 11101, 11110 or 11111 code table 8, (300.8) would be used to encode the nth symbol.

The following table illustrates, some further possible embodiments that can be implemented, and certain parameters thereof. The present disclosure should not be considered to be limited to such examples.

| First data type code length | Second data type code length | Compression ratio | Number of Lossless symbols | Number of Lossy symbols | Lossy symbol group width | Worst Error | Possible field of use |
|---|---|---|---|---|---|---|---|
| 10 | 9 | 10:9 | 256 | 256 | 3 | ±1 | Video or still images |
| 10 | 8 | 10:8 | 128 | 128 | 7 | ±3 | Video or still images |
| 10 | 7 | 10:7 | 64 | 64 | 15 | ±7 | Video or still images |
| 24 | 11 | 24:11 | 1024 | 1024 | 16383 | ±8191 | Audio |
| 4 | 3 | 4:3 | 4 | 4 | 3 | ±1 | Fig. 2 (2A) |
| 5 | 4 | 5:4 | 8 | 8 | 3 | ±1 | Fig. 3 (3A) |

As will be appreciated, diagrams corresponding to figured 2 and 3 that indicate the set of predetermined transformations that may be used in the above embodiments of the present disclosure, (and others not listed that have different first and second data type code lengths) may be produced. However, as the code lengths of the first data type and second data type grow, the size of each subset of predetermined sets of transformations grows, as does the number of subsets of predetermined transformations, so that diagrammatic representation becomes unwieldy, and will not be performed). For example in the 10:9 example above, each code table would include 1024 columns of transformations and there would be 257 code tables (i.e. 257 subsets of predetermined transformations).

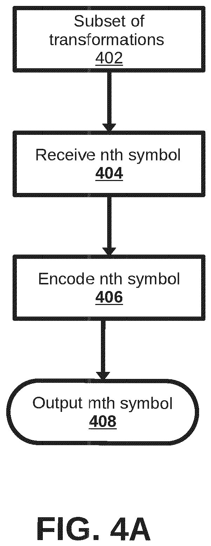

Fig. 4A is a flowchart illustrating an overview of the process implemented during encoding according to an embodiment of the present disclosure. The method of Fig. 4A is able to be used to encode a data sequence comprising symbols of first data type to thereby generate a second data sequence comprising symbols of a second data type. The process begins by determining a subset of transformations 402 from a set of predetermined transformations that are defined according to the first and second data types that will be used to encode the next received symbol of the first data sequence. In embodiments of the present disclosure each subset of transformations within the set of predetermined transformations includes both lossy and lossless transformations between the first data type and the second data type. For all received data symbols, after the first data symbol, the subset of transformations used to encode the symbol (nth symbol) is based on the symbol received before it (n-1th symbol).

At step 404 the nth symbol of the first data sequence is received. This may comprise receiving the data symbol on a serial data connection such as a network link or data bus which may provide data from a sensor, transducer, from memory or any other source. Next the nth symbol is encoded 406 according to the appropriate transformation from the subset of transformations identified in step 402. The encoded symbol represented in the second data type is then output 408 as the mth symbol of the second data sequence.

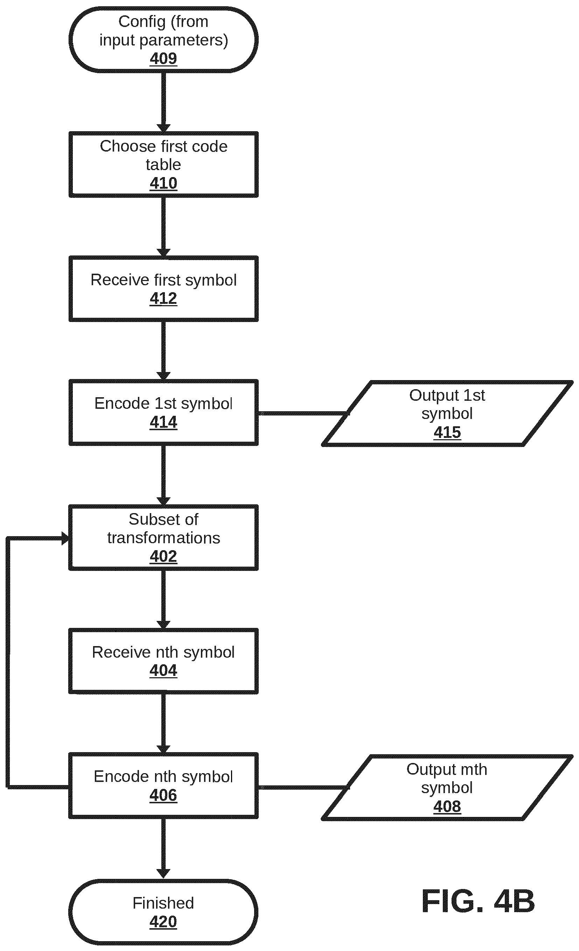

Fig. 4B illustrates an expanded embodiment of the method of Fig. 4A which includes a mechanism for initiating the encoding process. In some embodiments the encoding process may need to be adapted to fit data sequences of particular types, as opposed to it being a fixed encoding scheme. Thus the method of Fig. 4B begins art 409 by configuring the encoder by determining the parameters of the encoding process, namely the data type of the first data sequence, and data type of the second data sequence. These parameters effectively set the predetermined transformations that may be used to encode and decode the data sequences. Next at 410 the subset of predetermined transformations to be used to encode the first data symbol of the first data sequence is determined. This determination will typically be determined based on a rule. In some embodiments, each of the subsets of predetermined transformations (also referred to as code tables) are numbered from 0 to i based on the position of its lossless transforms, thus in one embodiment the 0th code table may be selected as the first code table, in others embodiments the last subset of transformations will be selected. In the illustrative embodiments described herein the central code table is selected to encode the first symbol of the first data sequence. Next the first symbol is received 412 and encoded 414 according to a corresponding transform defined in the subset of transformations determined in step 410, and output 415 as the first symbol of the second data sequence. This first symbol is also used in step 402 to determine the appropriate subset of transformations from the set of predetermined transformations to be used to select the transformation to be applied to the next symbol (nth symbol) in step 404. The process continues until all symbols of the first data sequence are encoded by step 406 and output 408. As noted above step 402 can include optional substeps of decoding the n-1th symbol using the same process as the decoder, to determine an expected decoded value n*-1 corresponding to the n-1th symbol, and to use this expected value to select the appropriate subset of transformations from the set of predetermined transformations for encoding the next symbol (nth symbol). Processing finishes as step 420.

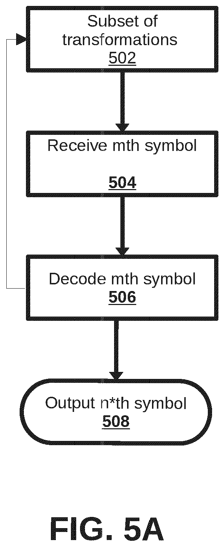

Fig. 5A is a flowchart illustrating an overview of the process implemented during the decoding according to the present disclosure. The process is able to be used to decode a data sequence comprising symbols of second data type to thereby generate a third data sequence comprising a symbols of the first data type. The process begins by determining a subset of transformations 502 from a set of predetermined transformations that are defined according to the first and second data types that will be used to decode the next received symbol of the second data sequence. For all received data symbols, after the first data symbol, the subset of transformations used to decode the symbol (mth symbol) is based on the symbol decoded before it (m-1th symbol decoded to the n*-1th symbol).

At step 504 the mth symbol of the second data sequence is received. This may comprise receiving the data symbol on a serial data connection such as a network link or data bus which may provide data from a network or from memory, or any other source. Next the mth symbol is decoded 506 according to the appropriate transformation from the subset of transformations identified in step 502. The decoded symbol represented in the first data type is then output 508 as the n*th symbol of the third data sequence.

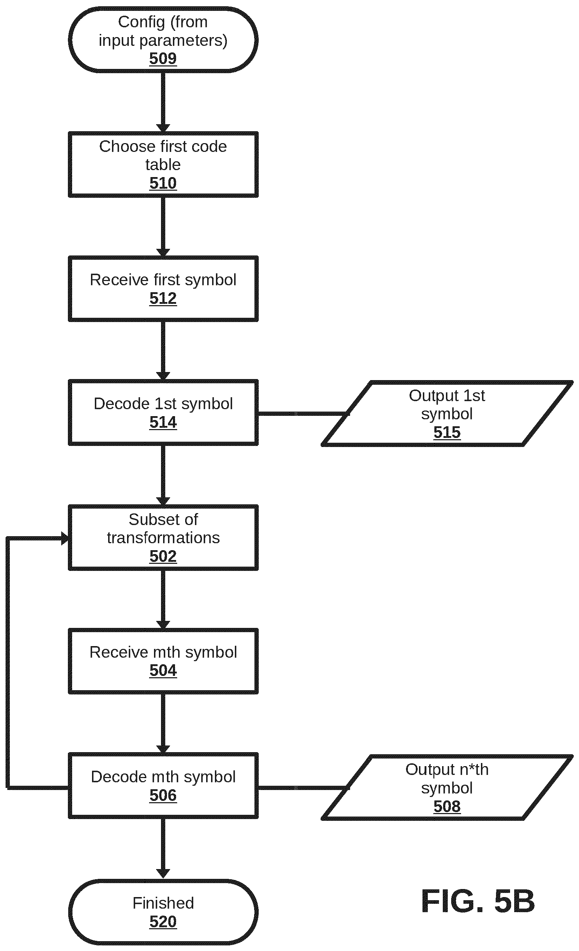

Fig. 5B illustrates an expanded embodiment of the method of Fig. 5A which includes a mechanism for initiating the decoding process. The initiating process should match the process used for encoding so that decoding and encoding operate in concert with each other. As with encoding the decoding process may need to be adapted to fit data sequences of particular types, as opposed to it being a fixed encoding scheme. Thus the method of Fig 5B begins at 509 by configuring the decoder by determining the parameters of the decoding process, namely the data type of the first data sequence, and data type of the second data sequence. These parameters effectively set the predetermined transformations that may be used to encode and decode the data sequences.

Next at 510 the subset of predetermined transformations to be used to decode the first data symbol of the second data sequence is determined. This will typically be determined based on a rule which will be the same rule used for initiating encoding. Next the first symbol is received 512 and decoded 514 according to a corresponding transform defined in the subset of transformations determined in step 510 and output 515 as the first symbol of the output data sequence. The decoded symbol is also then used in step 502 to determine the appropriate subset of transformations from the set of predetermined transformations to be used to select the transformation to be applied to the next symbol (m+1th symbol) in step 504. In step 506 the mth symbol is decoded to the n*th symbol and output 508. The process continues until all symbols of the second data sequence are decoded and then concludes at step 520.

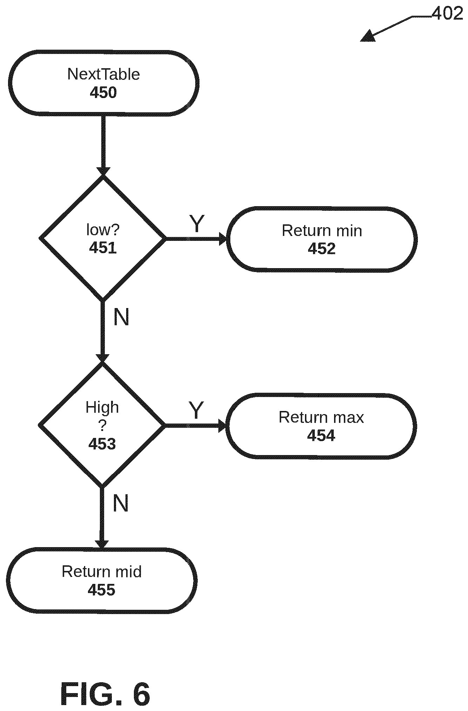

A more detailed example of an embodiment will now be described with the aid of Figures 6 to 10, which are flowcharts showing steps in exemplary implementations of portions of the method. Some sections of the following descriptions are expressed in C pseudo code. These sections are shown in bold. The mathematical operators in these sections are those of the C language:

| Symbol | Meaning | Symbol | Meaning |
|--------|---------|--------|---------|
| + | Addition | & | Bitwise AND |
| - | Subtraction | \| | Bitwise OR |
| * | Binary operator: Multiplication | ^ | Bitwise XOR |
| * | Unary operator: Pointer lookup (load or store) | ~ | Bitwise NOT |
| / | Integer division | -> | Structure member |
| << | Left bit shift | ++ | Increment |
| >> | Right bit shift | | |

In expressions that use multiple operators the precedence of those operators follow the normal C conventions.
For convenience, in the following description a codeword of the first data type will be called a "sample". This terminology is most apt if the data being encoded represent a digital sample of an analog process such as image or sound capture, although it should be noted that the codeword may not represent a sample, and the present disclosure should not be considered to be limited to such usage.
In many implementations it will be necessary to first conFig. the encoder or decoder for the particular configuration of raw input data (in the first data type), coded data (in the second data type). These can be specified by defining sample_bits to be equal to the code length of the first data type, and **coded_bits** to be equal to the code length of the second data type.
This allows the following values for the given codec configuration to be determined:

**cfg->sample_states = 1 << sample_bits;**

**cfg->coded_states = 1 << coded_bits;**

**cfg->lossy_code_width = (1 << (sample_bits - coded_bits + 1)) - 1;**

**cfg->lossy_rounding = cfg->lossy_code_width / 2;**

**cfg->lossless_codes = cfg->coded_states / 2;**

**cfg->lossy_codes = cfg->coded_states / 2;**

**cfg->code_tables = 1 + cfg->coded_states / 2;**

**cfg->default_table = cfg->code_tables / 2;**

**cfg->lowest_table_thresh = cfg->lossless_codes / 2;**

**cfg->highest_table_thresh = cfg->sample_states - (cfg->lossless_codes / 2);**

**cfg->lossy_flag = (1 << coded_bits) / 2**

Fig. 6 s a flowchart that describes the "Next Table" process. The "Next table process" (e.g. as performed in step 402 in Fig. 4A) is necessary because the codec of the present disclosure is context adaptive. That is, different encoding tables, representing different subsets of transformations between the first and second data types, are used in different contexts. The encoder and decoder jointly and unanimously decide which code table to use by convention. This means that the encoder need not transmit a message saying which table to use - instead the encoder and decoder work in lockstep and know which table to use according to the previously transmitted sample. The convention used in one embodiment is set out in Fig. 6.
Processing commences at either the encoder or decoder at step 450 with a configuration argument **(cfg)** and a second argument that is the most recently decoded sample (sample). Processing then proceeds to step 451. In step 451 the most recently decoded sample value is compared with the constant **cfg->lowest_table_thresh.** If it is lower than **cfg-**

**>lowest_table_thresh** then processing switches to step 452 otherwise processing switches to step 453.

In step 452 the process terminates by returning the identification number of the lowest encoding table, which is the value 0.

In step 453 the most recent decoded sample value is compared with the constant **cfg->highest_table_thresh.** If it is greater than or equal to **cfg->highest_table_thresh** then processing switches to step 454 otherwise processing switches to step 455.

In step 454 the process terminates by returning the identification number of the highest encoding table, which is the value **cfg->lossy_codes.**

In step 455 the process terminates by returning the identification number of one of the intermediate encoding tables, which is calculated as

$$\text{(sample - cfg->lowest\_table\_thresh + cfg->lossy\_rounding) / cfg->lossy\_code\_width}$$

Noting that in Fig. 6 the variable **sample** represents the decoded value of the last sample, which may be computed in the encoder by decoding the most recently coded value, or which is the output of the decoder.

As discussed above, this process will not work for determining the code table for use in encoding the first sample value, as there is no previous sample to base the selection upon. Accordingly both encoder and decoder need to be initialized/configured before transmission begins. By convention both the encoder and decoder select the "middle" code table from amongst those available:

$$\text{initial table = (number of tables) / 2}$$

As noted above, a different convention may be selected, so long as the encoder and decoder use the same convention.

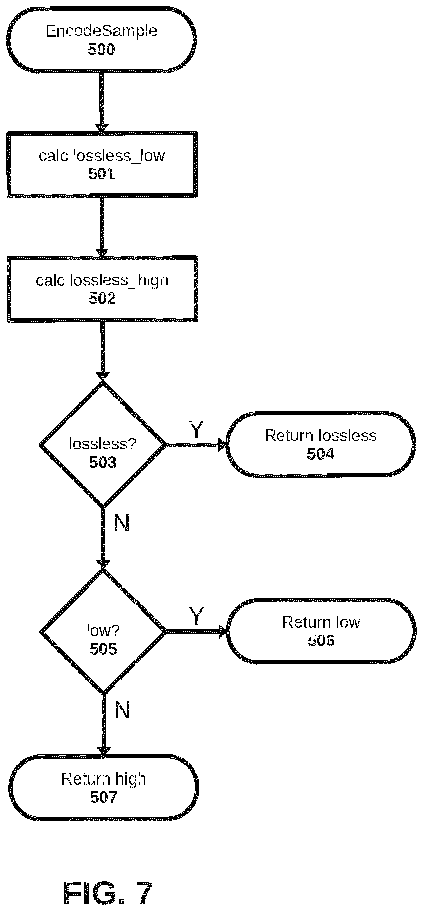

Fig. 7 is a flowchart that describes the "Encode Sample" process represented in step 406 of Fig. 4A. Processing commences at step 500 with the codec configuration information **cfg,** an encoding table number **table** (that indicates which of the subsets of predetermined transformations will used for encoding the next symbol of the first data sequence) and the next symbol in the first data sequence **sample.** Processing then proceeds to step 501.

In step 501 the variable **lossless_low** is calculated as

$$\text{lossless\_low = table * cfg->lossy\_code\_width}$$

Next in step 502 the variable lossless_high is calculated as

$$\text{lossless\_high = lossless\_low + cfg->lossless\_codes}$$

Next in step 503 the input symbol **sample** is compared with lossless_low and lossless_high; and if it is greater than or equal to lossless_low and also less than lossless_high, then **sample** will be transmitted losslessly using step 504.

In step 504 the process terminates by generating an output codeword encoded in the second data type that losslessly represents **sample,** which is calculated as

$$\text{sample - lossless\_low}$$

In step 505 the **sample** is compared with lossless_low; if it is less than lossless_low then the sample can only be transmitted in the "lower lossy" range, i.e. a group of lossy transformations with values lower than the lowest end of the group of lossless transformations.

In step 506 the process returns a lossy codeword that represents the input image sample in the second data type, which is calculated as

$$\text{cfg->lossy\_flag | (sample / cfg->lossy\_code\_width)}$$

In the alternative, **sample** must have a value higher than the group of values which are losslessly transformed and in step 507 the process terminates by returning a lossy codeword that represents the input image sample in the second data type, which is calculated as

$$\text{cfg->lossy\_flag | ((sample - lossless\_high) / cfg->lossy\_code\_width + table)}$$

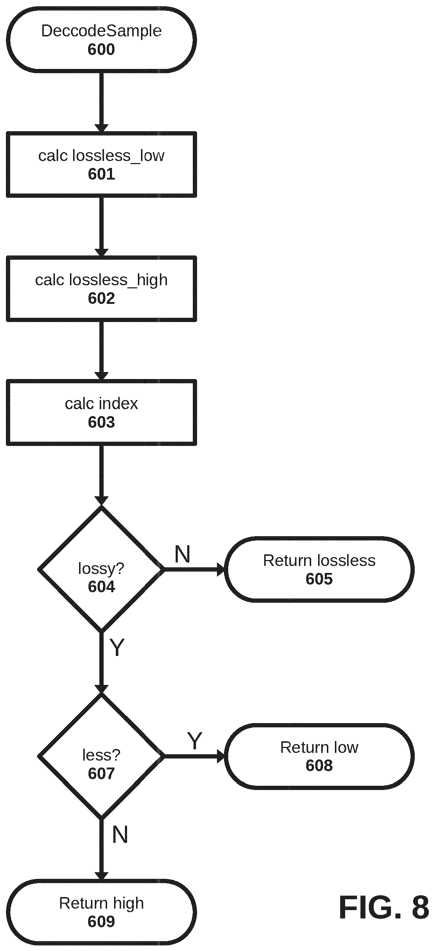

As noted above decoding is similar to encoding, and may be performed at a decoder, or within an encoder to determine the input value for the "next table" process discussed in relation to Fig. 6. Fig. 8 is a flowchart that describes the "Decode Sample" process.

Processing commences at step 600 with configuration information **cfg,** an encoding table number **table** determined in accordance with Fig. 6, and an encoded value being the mth symbol of the second data sequence **code_word** that is a member of the second data type. Processing begins at step 601, wherein the variable **lossless_low** is calculated as

$$lossless\_low = table * cfg\text{-}{>}lossy\_code\_width$$

Next, in step 602 the variable lossless_high is calculated as

$$lossless\_high = lossless\_low + cfg\text{-}{>}lossless\_codes$$

Next, in step 603 the variable index is calculated as

$$index = code\_word \, \& \sim cfg\text{-}{>}lossy\_flag$$

Next at step 604 the **code_word** is checked for the presence of the "Lossy" flag; if it is found then processing switches to step 607, otherwise processing switches to step 605. The presence of the "Lossy" flag is calculated as if

$$(code\_word \, \& \, cfg\text{-}{>}lossy\_flag)$$

If the lossy flag is not present (i.e. the transformation was lossless), in step 605 the process returns the decoded lossless sample which is calculated as

$$lossless\_low + index$$

If the lossy flag is present, in step 607 the variables **index** and **table** are compared. If **index** is less than **table** then processing switches to step 608 otherwise it switches to step 609.

In step 608 the process terminates by returning the low range decoded lossy sample which is calculated as

$$index * cfg\text{-}{>}lossy\_code\_width + cfg\text{-}{>}lossy\_rounding$$

In step 609 the process terminates by returning the high range decoded lossy sample which is calculated as

$$(index - table) * cfg\text{-}{>}lossy\_code\_width + lossless\_high + cfg\text{-}{>}lossy\_rounding$$

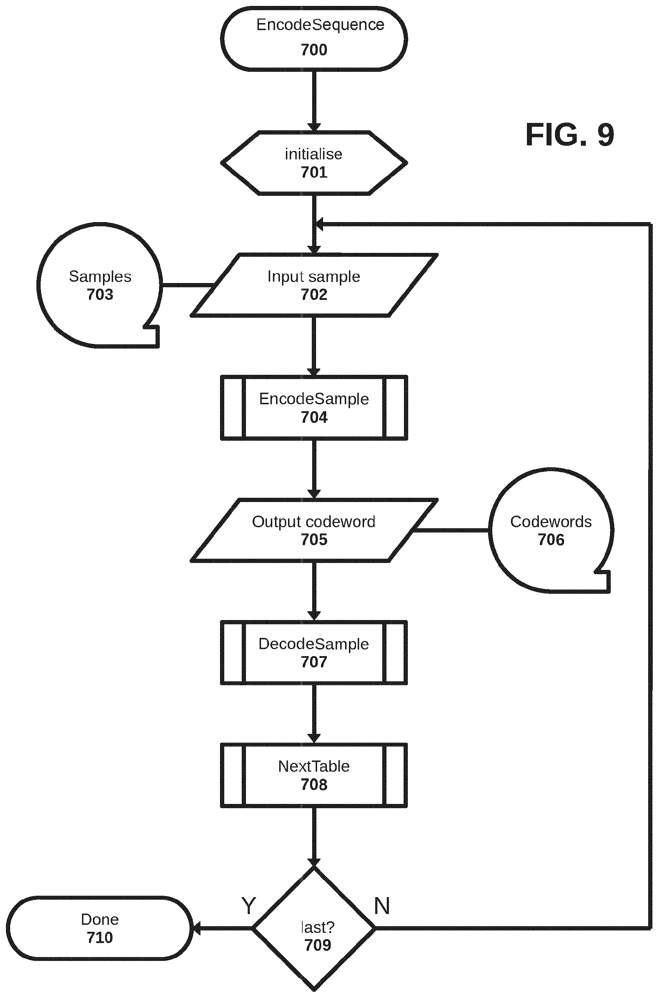

Fig. 9 is a flowchart that describes an "Encode Sequence" process that illustrates an embodiment of a process performed by an encoder (e.g. 102) to sequentially encode a first data sequence to create a second data sequence.

Processing commences at step 700 with input arguments of a configuration data **cfg,** the first data sequence comprising a sequence of input image samples **sampin,** a pointer to a buffer for receiving the second data sequence comprising encoded code words **codeout** and the number of input image samples **samples.** Processing then proceeds to step 701.

In step 701 the variables **table** and i are initialised:

$$table = cfg\text{-}{>}default\_table$$

$$i = 0$$

Next in step 702 the next sample is read from the sequence of input image samples 703:

$$*sampin{+}{+}$$

Next, in step 704 the process of Fig. 7 is performed as **"EncodeSample"** using configuration arguments **cfg, table** and the image sample obtained in step 702. On return the result is stored in variable **code_word** and processing proceeds to step 705.

In step 705 the variable **code_word** is written to the buffer for receiving encoded code words 706:

$$*codeout++ = code\_word$$

In order to accurately determine the code table to be used for the next codeword of the sequence of first codewords, at 707 the process **DecodeSample** of Fig. 7 is called with arguments **cfg, table** and **code_word.** On return the result is stored in variable **decoded** and processing proceeds to step 708.

In step 708 the predefined process **NextTable** of Fig. 6 is called with arguments **cfg** and **decoded.** On return the result is stored in variable **table** and processing proceeds to step 709.

In step 709 the variable i is incremented and compared with argument **samples.** If i is less than **samples** then processing returns to step 702, otherwise processing terminates at step 710.

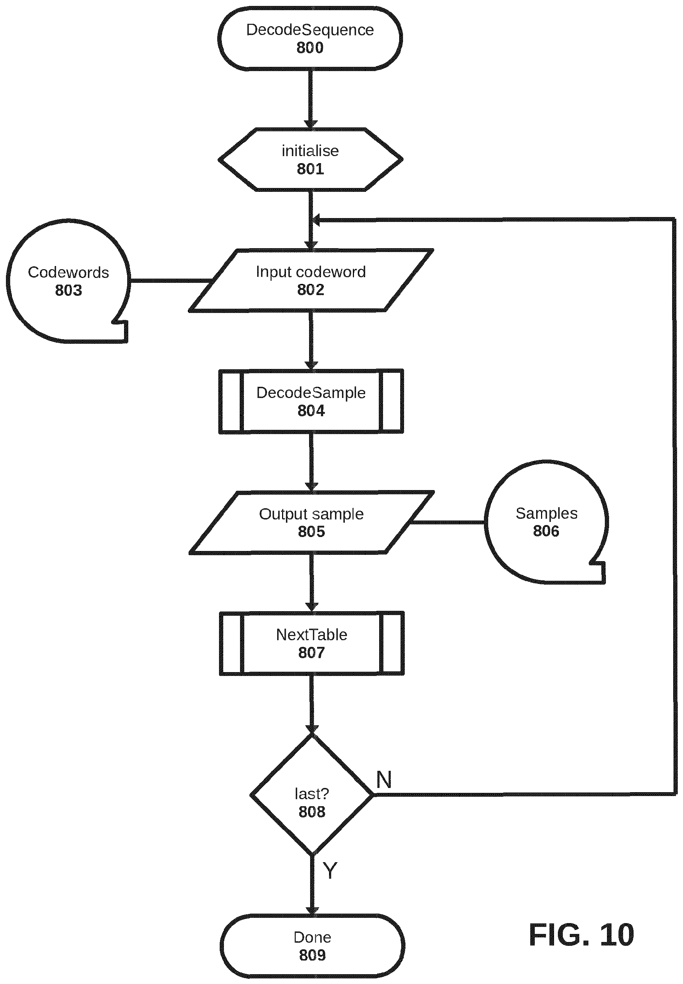

Fig. 10 is a flowchart that describes the "Decode Sequence" process that is used by a decoder (e.g. 104) to decode the second data sequence and generate the third data sequence comprising symbols according to the first data type.

Processing commences at step 800 with input arguments of configuration data **cfg,** the second data sequence comprising a sequence of input codewords in the second data type **codein,** a pointer to a buffer for receiving decoded samples in the first data type **sampout** and the number of input image samples **samples.** Processing then proceeds to step 801.

In step 801 the variables **table** and **i** are initialised:

$$table = cfg->default\_table$$

$$i = 0$$

Next in n step 802 the next codeword is read from the sequence of input codewords 803:

$$*codein++$$

Next, in step 804 the predefined process **DecodeSample** of Fig. 8 is called with arguments **cfg, table** and the codeword obtained in step 802. On return the result is stored in variable **decoded** and Processing then proceeds to step 805.

In step 805 the variable **decoded** is written to the buffer for receiving decoded samples 806:

$$*sampout++ = decoded$$

This generates the output samples which are again encoded in the first data type.

Processing then proceeds to step 807. In step 807 the predefined process **NextTable** of Fig. 6 is called with arguments **cfg** and **decoded** to enable correct decoding of the next sample of the second data sequence using the correct subset of predetermined transformations. On return the result is stored in variable **table** and processing proceeds to step 808.

In step 808 the variable i is incremented and compared with argument **samples.** If i is less than samples then processing switches to step 802, otherwise processing terminates at step 809.

The methods of figures 6 through 10 can be implemented with C code set out in **Appendix A.**

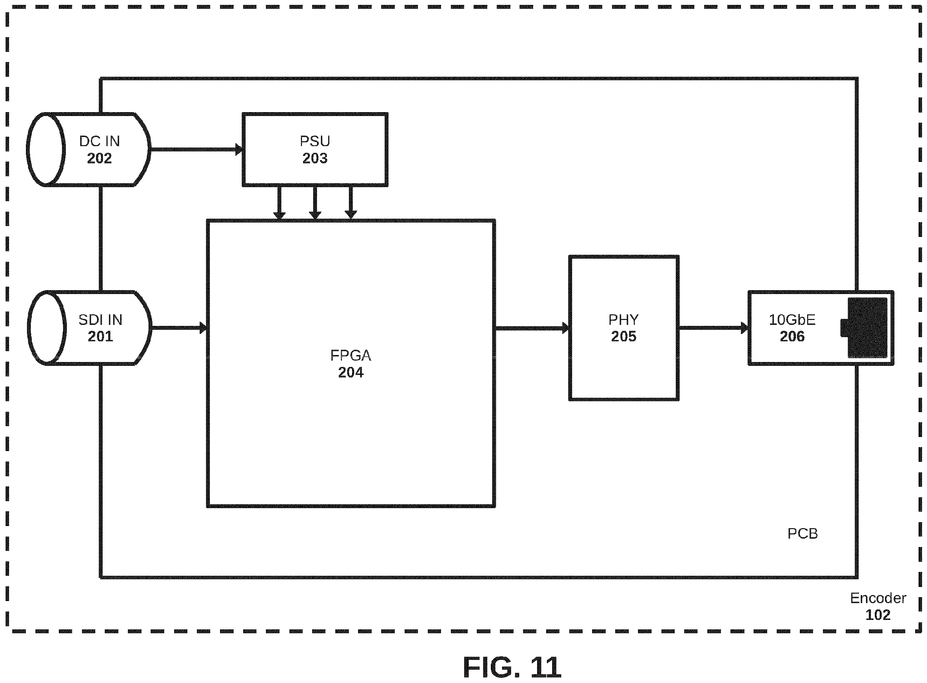

Fig. 11 is a schematic block diagram of an encoder 102 that may implement an embodiment of the present disclosure. This example is adapted to receive video data via an SDI input 201 and output the encoded data on an ethernet network connection 206. The encoder 102 includes a power supply system comprising a PSU 203 and a DC input jack 202 to which a DC power source can be connected. The encoder 102 includes a data processing system in the form of an FPGA 204 which performs data processing required by the encoding methods described above. The first data sequence is received as serial data on an SDI connection to the SDI in port 201. The SDI video may come from any video source, such as a video player, camera or the like. After encoding the second data sequence is output on an ethernet connection coupled to the ethernet port 206. The ethernet physical layer encoding of the output second data sequence is performed by PHY 205.

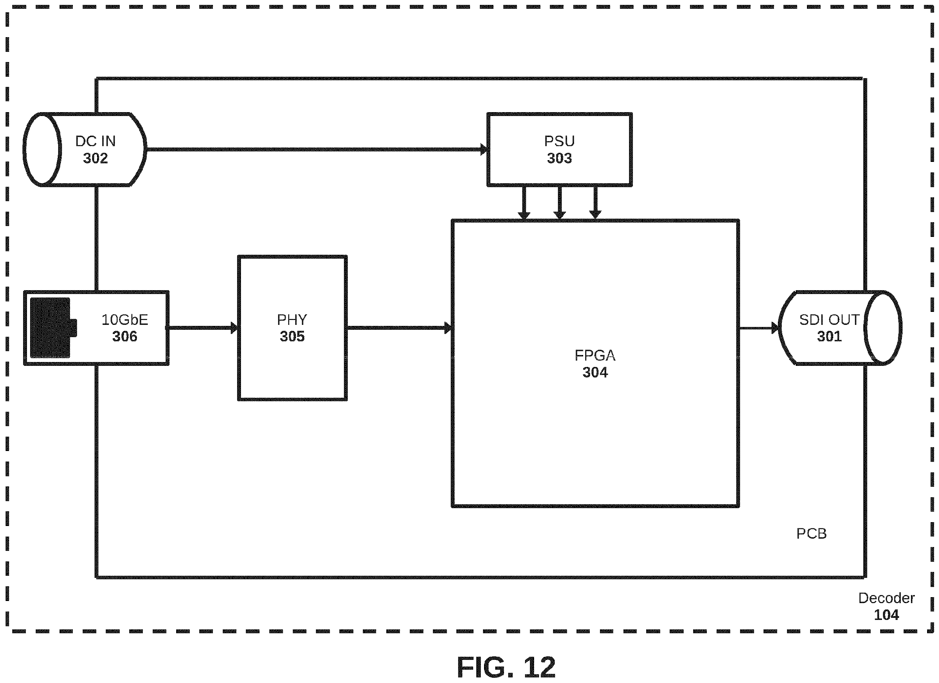

Fig. 12 is a schematic block diagram of a decoder 104 that may implement an embodiment of the present disclosure. This example is adapted to receive video data via ethernet connection and output the encoded data on an SDI output 301. The decoder 104 includes a power supply system comprising a PSU 303 and a DC input jack 302 to which a DC power source can be connected. The decoder 104 includes a data processing system in the form of an FPGA 304 which performs data processing required by the decoding methods described above. The second data sequence is received on an ethernet connection 306. The ethernet physical layer coding of the stream is performed by PHY 305. The second data sequence is processed by the FPGA 304 and output as a third sequence of data that is represented in the first data type and output via the SDI out port 301. The SDI output signal video may be sent to any video consumer, such as a video player, recorder, format converter, switch etc.

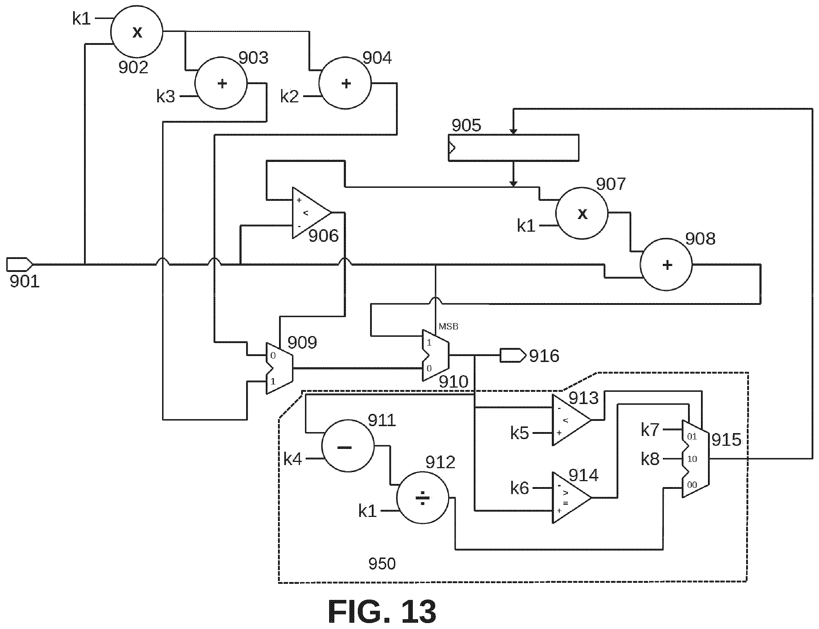

Fig. 13 is a circuit diagram that shows a circuit that may be implemented to perform the "Decode Sample" method as part of either an encoding or decoding process as set out above. The circuit may be part of a data processor in an embodiment of the present disclosure, for example it may form part of the functionality of the FPGA 204 or 304 in figures 11 or 12.

The circuit is arranged to perform decoding in a 10:8 encoding/decoding embodiment of the present disclosure. The circuit receives an input of a code word 901 which is a codeword according to the second data type (8 bits) and outputs a decoded sample 916 of 10 bits, according to the first data type. The circuit is a digital logic circuit composed of circuit elements including adders, subtracters, comparators, multipliers, dividers, multipliers, multiplexers and registers.

Some of the circuit elements have input terminals connected to constant values, labelled k1 through k8. For the present 10:8 decoder example these constants take the following values:

| k1 | 7 | k5 | 64 |
|---|---|---|---|
| k2 | 3 | k6 | 960 |
| k3 | 131 | k7 | 0 |
| k4 | 62 | k8 | 128 |

In general, the group of circuit elements indicated by block 950 are arranged to determine the next coding table to be used for decoding the subsequent sample. The remaining elements decode the current input sample symbol received at 901 and output decoded value at output 916.

Circuit elements 902 and 907 are multipliers that accept unsigned integers on each of their input ports (on the left side of each multiplier). Each multiplier 902 and 907 outputs the product of its two input ports on its output port (on the right side of each multiplier).

Circuit element 902 multiplies the lowest 7 bits of 901 with constant k1, producing a 10 bit output. Circuit element 907 multiplies the output of 905 with constant k1, producing a 10 bit output.

Circuit elements 903, 904 and 908 are adders that accept unsigned integers on each of their input ports (on the left side of the adder). Each adder outputs the sum of its two input ports on its output port (on the right side of the adder). Circuit element 903 takes the output of 902 and adds constant k3 to it, producing a 10 bit output. Circuit element 904 takes the output of 902 and adds constant k2 to it, producing a 10 bit output. Circuit element 908 takes the output of 907 and adds the lowest 7 bits of 901 to it, producing a 10 bit output.

Circuit element 911 is a subtracter that accepts unsigned integers on each of its input ports (on the left side of the subtracter). The subtracter outputs the difference of its two input ports on its output port (on the right side of the subtracter). The difference is calculated by subtracting the value on the bottom left input port from the value on the top left input port. Circuit element 911 subtracts the constant k4 from 916, producing a 10 bit output.

Circuit element 912 is a divider that accepts unsigned integers on each of its input ports (on the left side of the divider). The divider outputs the value on the top left input port divided by the value on the bottom left input port. The output port is the port on the right side of the divider. Circuit element 912 divides the output of 911 by constant k1, producing a 9 bit output.

Circuit elements 906 and 913 are "less than" comparators. Each has two input terminals, labelled "-" and "+". If the number present at the "-" input is less than the number on the "+" input then it outputs a high/1/true signal. Circuit element 906 compares the output of 905 with the lowest 7 bits of 901. Circuit element 913 compares 916 with the constant k5.

Circuit element 914 is a "greater than or equal to" comparator. It has two input terminals, labelled "-" and "+". If the number present at the "+" input is greater than or equal to the number on the "-" input then it outputs a true (logical 1) signal. Circuit element 914 compares 916 with the constant k6.

Circuit elements 909 and 910 are two input multiplexers. Each has two data input terminals, labelled "0" and "1". Each also has a selection input terminal, which is unlabelled. Each multiplexer also has a data output terminal, located on its right side. If the selection input terminal is in the low/0/false state then the multiplexer outputs the value present on the "0" data input terminal. If the selection input terminal is in the high/1/true state then the multiplexer outputs the value present on the "1" data input terminal. Circuit element 909 uses the output of 906 to select the output of 903 or the output of 904. Circuit element 910 uses the Most Significant Bit (MSB) (bit 7) of 901 to select the output of 908 or the output of 909.

Circuit elements 915 is a three way multiplexer. It has three data input terminals, labelled "00", "01" and "10". It has two selection input terminals, which have no labelling. It also has a data output terminal, located on its right side. If the left selection input terminal is low/0/false and the right selection input terminal is also low/0/false then the data output terminal outputs the value present on the "00" data input terminal.

If the left selection input terminal is low/0/false and the right selection input terminal is high/1/true then the data output terminal outputs the value present on the "01" data input terminal.

If the left selection input terminal is high/1/true and the right selection input terminal is low/0/false then the data output terminal outputs the value present on the "10" data input terminal.

Circuit elements 915 uses the outputs of 913 and 914 to select one of constant k7, constant k8 or the output of 912.

Circuit elements 905 is a register of 9 unsigned bits It accepts a value at its input port (at the top) and outputs a value from its output port (at the bottom). After the completion of the decoding of a sample the register 905 transfers a copy of the value at its input port to its output port. It then holds that value steady on its output port for the subsequent decoding operation.

Embodiments of the present disclosure may avoid the need for VLC data buffers as encoding is performed using an absolutely constant bit rate algorithm. In such embodiments each symbol of the first data sequence is compressed (encoded) to a fixed size symbol in the second data sequence that is smaller than the symbols of first data sequence. As every encoded symbol in the second data sequence (the compressed data sequence) has a fixed size there is no need for data buffers to cater for sequences of longer than expected encoded symbols, which may occur in VLC algorithms.

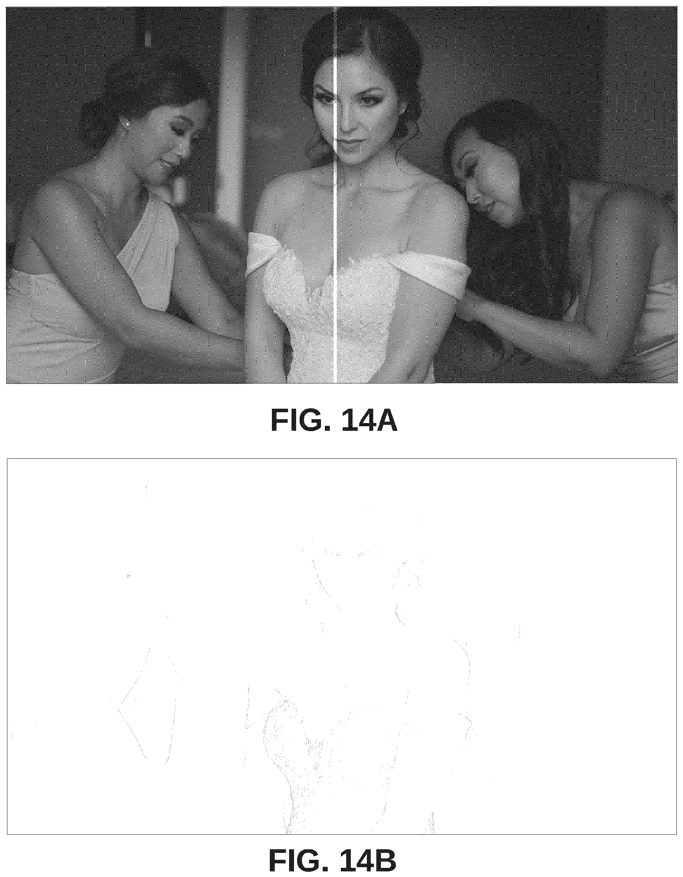

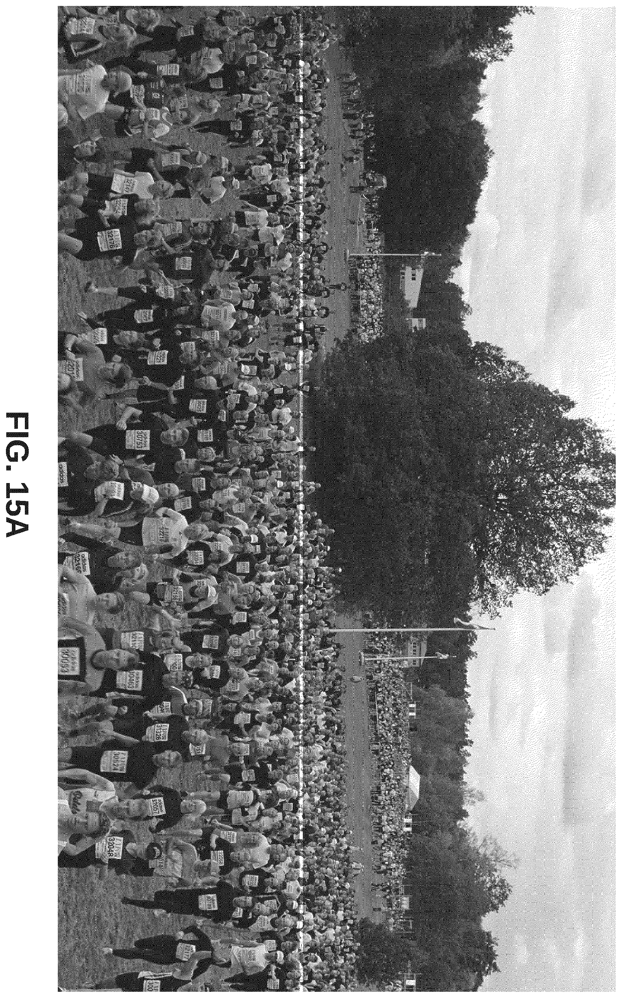

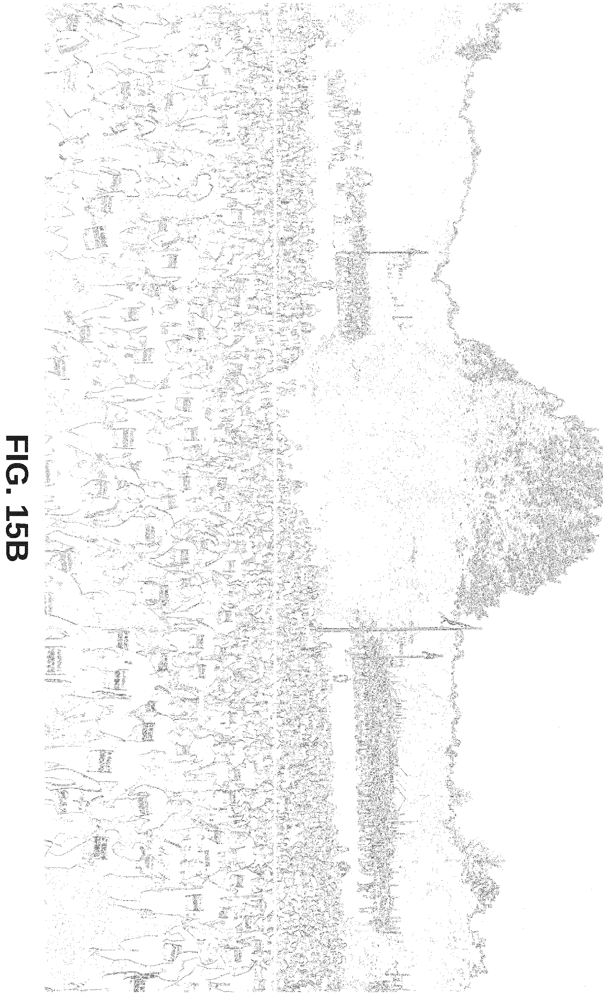

Embodiments of the present disclosure also have the property that they tend to use lossless compression when the first data sequence is slowly varying (i.e. each data value only varies by a small amount from the last value encoded). This can be seen in the code tables in the examples shown herein, in that if the nth symbol value is close to that of the n-1th symbol the nth symbol will be encoded within the lossless group of symbols. The algorithm switches to lossy compression when the change between sequentially received symbols is large (e.g. step changes in symbol values in the first data sequence as may occur where an edge occurs within in an image). However, even when lossy compression is required to be used, there is a strictly bounded error range defined within the set of transformations used. When considering encoded still or video images, embodiments may be mathematically lossless across smooth gradients and slightly lossy (but typically visually lossless) on edges. Figures 14A/14B and 15A/15B show examples of single images compressed using embodiments of the present disclosure. Fig. 14A shows an image (wedding image) coded in 10 bit codewords, originally in YUV format that has been compressed to 8 bit codewords. Fig. 14B shows a map of the image illustrating the location of lossless coded pixel values (white pixels) and lossy coded pixels (shaded pixels). Fig. 14B is a composite of all errors in the Y, U and V channels of this image. As can be seen using the with a 10:8 compression version of the present disclosure, in this image the vast majority of pixels are losslessly encoded, and the lossy pixels are located along edges within the image.

Fig. 15A shows an image (CrowdRun) coded in 10 bit codewords, originally in YUV format that has been compressed to 8 bit codewords. Fig. 15B shows a map of the image illustrating the location of lossless coded pixel values (white pixels) and lossy coded pixels (shaded pixels). Grey pixels indicate pixels in the Y channel that were transformed with a lossy mapping. Yellow pixels indicate pixels in the V channel that were transformed with a lossy mapping, and magenta pixels indicate pixels in the U channel that were transformed with a lossy mapping. When Fig. 15B is viewed in greyscale, grey pixels indicate pixels in the Y, U or V channels that were transformed with a lossy mapping. As can be seen using the with a 10:8 compression version of the present disclosure, even on a visually busy image with many edges the majority of pixels are losslessly encoded, and the lossy pixels are located along edges within the image. Even though there are errors present in the encoding of the images of figures 14A and 15A it should be noted that those errors are bounded. That is errors can never be greater than a given threshold set by the predetermined transformations.

Embodiments of the present disclosure provide a relatively simple methods of encoding/decoding a data sequence. Embodiments may not require signalling of the encoding scheme being applied or quantization step. In particular the quantization is essentially fixed (or not quantization is applied at all). And the determination of whether or not quantization needs to occur for a given symbol may be determined from the data sequence, both during encoding or decoding. This can be contrasted with many prior art systems that require one or more of:

quantisation information to be signalled to the decoder (e.g. with a fixed length adaptive code); use of different quantization on different channels (hence the need to signal); and/or use of non-linear quantization.

Any definitions expressly provided herein for terms contained in the appended claims shall govern the meaning of those terms as used in the claims. No limitation, element, property, feature, advantage or attribute that is not expressly recited in a claim should limit the scope of the claim in any way.

As used herein the terms "include" and "comprise" (and variations of those terms, such as "including", "includes", "comprising", "comprises", "comprised" and the like) are intended to be inclusive and are not intended to exclude further features, components, integers or steps.

For aspects of the disclosure that have been described using flowcharts, a given flowchart step could potentially be performed in various ways and by various devices, systems or system modules. A given flowchart step could be divided into multiple steps and/or multiple flowchart steps could be combined into a single step, unless the contrary is specifically noted as essential. Furthermore, the order of the steps can be changed without departing from the scope of the present disclosure, unless the contrary is specifically noted as essential.

It will be understood that the present invention has been described above purely by way of example, and modifications of detail can be made within the scope of the invention.

Reference numerals appearing in the claims are by way of illustration only and shall have no limiting effect on the scope of the claims.

**Appendix A**

*This Appendix contains material which is subject to copyright protection. The copyright owner has no objection to the facsimile reproduction of the Appendix as part of the patent specification or patent office records but otherwise reserves all copyright rights.*

Example C code for "Demoencoder"

```
#include <stdlib.h>

#include <stdio.h>


typedef signed char s8;

typedef unsigned char u8;

typedef signed short s16;

typedef unsigned short u16;

typedef signed int s32;

typedef unsigned int u32;

typedef signed long long s64;

typedef unsigned long long u64;


typedef struct

{

u32 sample_states;

u32 coded_states;

u32 lossy_code_width;

u32 lossy_rounding;

u32 lossless_codes;

u32 lossy_codes;

u32 code_tables;

u32 default_table;

u32 lowest_table_thresh;
```

```
    u32 highest_table_thresh;

    u32 lossy_flag;

} DemoencoderCfg;


// Calculate constants needed by the specified flavour of Demoencoder

void SetupDemoencoder(DemoencoderCfg *cfg, u32 sample_bits, u32 coded_bits)

{

    cfg->sample_states = 1 << sample_bits;

    cfg->coded_states = 1 << coded_bits;

    cfg->lossy_code_width = (1 << (sample_bits - coded_bits + 1)) - 1;

    cfg->lossy_rounding = cfg->lossy_code_width / 2;

    cfg->lossless_codes = cfg->coded_states / 2;

    cfg->lossy_codes = cfg->coded_states / 2;

    cfg->code_tables = 1 + cfg->coded_states / 2;

    cfg->default_table = cfg->code_tables / 2;

    cfg->lowest_table_thresh = cfg->lossless_codes / 2;

    cfg->highest_table_thresh = cfg->sample_states - (cfg->lossless_codes / 2);

    cfg->lossy_flag = (1 << coded_bits) / 2;

}


// Use the decoded sample to select the next table to use

s32 NextTable(DemoencoderCfg *cfg, s32 sample)

{

if (sample < cfg->lowest_table_thresh)

return 0;

else if (sample >= cfg->highest_table_thresh)

return cfg->lossy_codes;

else

return (sample - cfg->lowest_table_thresh + cfg->lossy_rounding) / cfg->lossy_code_width;
```

```
}


// For a given sample and code table calculate the code word

s32 EncodeSample(DemoencoderCfg *cfg, s32 table, s32 sample)

{

s32 lossless_low = table * cfg->lossy_code_width;

s32 lossless_high = lossless_low + cfg->lossless_codes;


if (sample >= lossless_low && sample < lossless_high)

return sample - lossless_low;

else if (sample < lossless_low)

return cfg->lossy_flag | (sample / cfg->lossy_code_width);

else

return cfg->lossy_flag | ((sample - lossless_high) / cfg->lossy_code_width + table);

}


// For a given code word and code table decode the sample

s32 DecodeSample(DemoencoderCfg *cfg, s32 table, s32 code_word)

{

s32 index = code_word & ~cfg->lossy_flag;


if (code_word & cfg->lossy_flag)

if (index < table)

return index * cfg->lossy_code_width + cfg->lossy_rounding;

else

return index * cfg->lossy_code_width + cfg->lossy_rounding + cfg->lossless_codes;

else

return table * cfg->lossy_code_width + index;

}
```

```
// Demoencoder encode a sequence of samples

s32 EncodeSequence

(

DemoencoderCfg *cfg,

s16 *sampin,

s16 *codeout,

s32 samples

)

{

s32 i;

s32 code_word;

s32 decoded;

s32 table;

s32 table_old;


table = cfg->default_table;

printf("Encoder started. Table initialised to %3d\n", table);

for (i = 0; i < samples; ++i)

{

code_word = EncodeSample(cfg, table, *sampin++);

*codeout++ = code_word;

decoded = DecodeSample(cfg, table, code_word);

printf("Used table %3d ", table);

table_old = table;

table = NextTable(cfg, decoded);

printf("to encode sample %4d to codeword %3d. Decoder will decode %4d so ", sampin[-1], codeout[-1], de-
coded);

if (table_old == table)

printf("sticking with");
```

```
else

printf("changing to ");

printf(" table %3d\n", table);

}

}


// Demoencoder encode a sequence of samples

s32 DecodeSequence

(

DemoencoderCfg *cfg,

s16 *codein,

s16 *sampout,

s32 samples

)

{

s32 i;

s32 decoded;

s32 table;

s32 table_old;


table = cfg->default_table;

printf("Decoder started. Table initialised to %3d\n", table);

for (i = 0; i < samples; ++i)

{

decoded = DecodeSample(cfg, table, *codein++);

*sampout++ = decoded;

printf("Used table %3d ", table);

table_old = table;

table = NextTable(cfg, decoded);
```

```
printf("to decode codeword %3d to sample %4d so ", codein[-1], sampout[-1]);

if (table_old == table)

printf("sticking with");

else

printf("changing to ");

printf(" table %3d\n", table);

}

}


int main(int argc, char *argv[])

{

s16 source[16] = {1, 1, 2, 3, 5, 8, 13, 21, 34, 55, 89, 144, 233, 377, 610, 987};

s16 ethernet[16];

s16 decoded[16];

DemoencoderCfg c;


SetupDemoencoder(&c, 10, 8);

EncodeSequence(&c, source, ethernet, 16);

DecodeSequence(&c, ethernet, decoded, 16);

return 0;

}
```

## Claims

1. A computer-implemented method for compressing data involving transforming an nth symbol of a first data sequence into an mth symbol of a second data sequence, the computer-implemented method comprising:

   receiving the nth symbol of the first data sequence;
   generating the mth symbol of the second data sequence from the nth symbol of the first data sequence using a transformation belonging to a predetermined set of transformations mapping a first data type comprising a library of first symbols having a first code length to a second data type comprising a library of second symbols having a second code length that is shorter than said first code length; said predetermined set of transformations comprising a plurality of subsets of transformations, wherein each subset of transformations map the first data type to the second data type, and include a group of lossless transformations that losslessly map certain symbols of the first data type to symbols of the second data type, and at least one group of lossy transformations between remaining symbols of the first data type and the second data type;

the method being **characterized in that**
said transformation used to generate the mth symbol of the second data sequence from the nth symbol of the first data sequence is a member of a subset of transformations in which an n-1th symbol of the first data sequence is amongst the certain symbols that are losslessly mapped to a second symbol in said subset's group of lossless transformations.

2. The computer implemented method of claim 1 wherein in each subset of transformations the certain symbols of the first data type that are losslessly mapped to symbols of the second data type, represent a contiguous group of data values.

3. The computer implemented method of claim 2 wherein in each subset of transformations the, or each, group of remaining symbols of the first data type that are transformed with a lossy transformation into said the second data type represent a contiguous group of data values.

4. The computer implemented method of any one of the preceding claims wherein in each subset of transformations the second data type comprises a first number of symbols to which said certain symbols of the first data type are mapped losslessly and a second number of symbols to which the other symbols of the first data type are mapped lossily, wherein the first number of symbols and second number of symbols in the library of the second data are equal.

5. The computer implemented method as claimed in any one of the preceding claims which further includes, determining a next subset of transformations, for use in transforming the n+1th symbol of the first sequence of data, based on the nth symbol of the first data sequence; and transforming the n+1th symbol of the first sequence of data into the m+1th symbol of the second data sequence using a transformation from the next subset of transformations.

6. The computer implemented method as claimed in claim 5 wherein in the next subset of transformations the nth symbol is losslessly mapped to a symbol of the second data type.

7. The computer implemented method of claim 6 wherein the method further includes performing an inverse transformation of the mth symbol of the second sequence of data into the first data type using an inverse transformation that corresponds to a transformation in the same subset of transformations used to generate the mth symbol of the second sequence.

8. A computer implemented method for decompressing data involving decoding an mth symbol, of a second data sequence having a second data type comprising a library of second symbols having a second code length, that was created by encoding the nth symbol of a first data sequence having a first data type comprising a library of first symbols having a first code length, wherein the second code length is shorter than the first code length, said decoding generating an output symbol having said first data type, the computer implemented method comprising:

receiving the mth symbol of the second data sequence;
generating the output symbol using a transformation belonging to a predetermined set of transformations mapping the second data type to the first data type; said predetermined set of transformations comprising a plurality of subsets of transformations, wherein each subset of transformations map the second data type to the first data type; and
the method being **characterized in that**
said transformation used to generate the output symbol is a member of a subset of transformations selected on the basis of an output symbol corresponding to the m-1th symbol.

9. A computer implemented method as claimed in claim 8 wherein each subset of predetermined set of transformations correspond to a subset of predetermined transformations that are able to be used during encoding the second data sequence.

10. A computer implemented method as claimed in claim 8 or 9 wherein each subset of predetermined set of transformations include:
a group of transformations which are the direct reverses of a corresponding group of lossless transformations that may be used to encode the first data sequence into the second data sequence, and a plurality of remaining transformations that correspond to a plurality of groups of lossy transformations between the first data type and second data type that may be used to encode the first data sequence into the second data sequence.

11. A computer implemented method as claimed in any one of claims 8 to 10 which further includes setting a predetermined subset of transformations mapping the second data type to the first data type for use in decoding the m+1th symbol of the second data sequence.

12. An encoding device comprising:

an input on which a first data sequence is received; said first data sequence comprising a first data symbols of a first data type and having a first code length,
an output on which a second data sequence is transmitted; said second data sequence comprising a second data symbols of a second data type and having a second code length that is different to said first code length;
a processing system configured to process received symbols of the first data sequence in series and output symbols of the second data sequence; wherein the processing system is configured to perform a method as claimed in any one of claims 1 to 7.

13. An encoding device as claimed in claim 12 wherein the device is further adapted to perform a method of decoding an mth symbol of a second data sequence having a second data type and being created by encoding the nth symbol of a first data sequence having a first data type, said decoding generating an output symbol having said first data type, the method comprising:

receiving the mth symbol of the second data sequence;
generating the output symbol using a transformation belonging to a predetermined set of transformations mapping the second data type to the first data type; said predetermined set of transformations comprising a plurality of subsets of transformations, wherein each subset of transformations map the second data type to the first data type; and
wherein said transformation used to generate the output symbol is a member of a subset of transformations selected on the basis of an output symbol corresponding to the m-1th symbol.

14. A decoding device comprising:

an input on which a second data sequence is received; said second data sequence comprising a second data symbols of a second data type and having a second code length,
an output on which output symbols are transmitted, said output symbols having a first data type corresponding to a first data type of a first data sequence that was encoded to form the second data sequence;
a processing system configured to process received symbols of the second data sequence in series and output symbols of the third data sequence with the same data type as the first data sequence;
wherein the processing system is configured to perform a method as claimed in any one of claims 8 to 11.

**Patentansprüche**

1. Computerimplementiertes Verfahren zum Komprimieren von Daten, das Transformieren eines n. Symbols einer ersten Datensequenz in ein m. Symbol einer zweiten Datensequenz beinhaltend, wobei das computerimplementierte Verfahren Folgendes umfasst:

Empfangen des n. Symbols der ersten Datensequenz;
Erzeugen des m. Symbols der zweiten Datensequenz aus dem n. Symbol der ersten Datensequenz unter Verwendung einer Transformation, die zu einem festgelegten Satz von Transformationen gehört, die eine erste Datenart, die eine Bibliothek erster Symbole mit einer ersten Codelänge umfasst, in eine zweite Datenart abbilden, die eine Bibliothek zweiter Symbole mit einer zweiten Codelänge umfasst, die kürzer als die erste Codelänge ist; wobei der festgelegte Satz von Transformationen mehrere Teilmengen von Transformationen umfasst, wobei jede Teilmenge von Transformationen die erste Datenart in die zweite Datenart abbildet und eine Gruppe verlustloser Transformationen, die bestimmte Symbole der ersten Datenart verlustlos in Symbole der zweiten Datenart abbildet, und mindestens eine Gruppe verlustbehafteter Transformationen zwischen verbleibenden Symbolen der ersten Datenart und der zweiten Datenart beinhaltet;
wobei das Verfahren **dadurch gekennzeichnet ist, dass** die Transformation, die zum Erzeugen des m. Symbols der zweiten Datensequenz aus dem n. Symbol der ersten Datensequenz verwendet wird, ein Element einer Teilmenge von Transformationen ist, in denen sich ein n-1. Symbol der ersten Datensequenz unter den bestimmten Symbolen befindet, die verlustlos in ein zweites Symbol in der Gruppe verlustloser Transformationen der Teilmenge abgebildet werden.

2. Computerimplementiertes Verfahren nach Anspruch 1, wobei in jeder Teilmenge von Transformationen die bestimmten Symbole der ersten Datenart, die verlustlos in Symbole der zweiten Datenart abgebildet werden, eine durchgehende Gruppe von Datenwerten darstellen.

3. Computerimplementiertes Verfahren nach Anspruch 2, wobei in jeder Teilmenge von Transformationen die oder jede Gruppe verbleibender Symbole der ersten Datenart, die mit einer verlustbehafteten Transformation in die zweite Datenart transformiert werden, eine durchgehende Gruppe von Datenwerten darstellt.

4. Computerimplementiertes Verfahren nach einem der vorhergehenden Ansprüche, wobei in jeder Teilmenge von Transformationen die zweite Datenart eine erste Anzahl von Symbolen umfasst, in welche die bestimmten Symbole der ersten Datenart verlustlos abgebildet werden, und eine zweite Anzahl von Symbolen, in welche die anderen Symbole der ersten Datenart verlustbehaftet abgebildet werden, wobei die erste Anzahl von Symbolen und die zweite Anzahl von Symbolen in der Bibliothek der zweiten Daten gleich sind.

5. Computerimplementiertes Verfahren nach einem der vorhergehenden Ansprüche, das ferner das Bestimmen einer nächsten Teilmenge von Transformationen zur Verwendung bei der Transformation des n+1. Symbols der ersten Datensequenz, basierend auf dem n. Symbol der ersten Datensequenz; und das Transformieren des n+1. Symbols der ersten Datensequenz in das m+1. Symbol der zweiten Datensequenz unter Verwendung einer Transformation von der nächsten Teilmenge von Transformationen beinhaltet.

6. Computerimplementiertes Verfahren nach Anspruch 5, wobei das n. Symbol in der nächsten Teilmenge von Transformationen verlustfrei in ein Symbol der zweiten Datenart abgebildet wird.

7. Computerimplementiertes Verfahren nach Anspruch 6, wobei das Verfahren ferner das Durchführen einer inversen Transformation des m. Symbols der zweiten Datensequenz in die erste Datenart unter Verwendung einer inversen Transformation, die einer Transformation in der gleichen Teilmenge von Transformationen entspricht, die zum Erzeugen des m. Symbols der zweiten Sequenz verwendet werden, beinhaltet.

8. Computerimplementiertes Verfahren zum Dekomprimieren von Daten, das Decodieren eines m. Symbols einer zweiten Datensequenz mit einer zweiten Datenart, die eine Bibliothek zweiter Symbole mit einer zweiten Codelänge umfasst, die durch Codieren des n. Symbols einer ersten Datensequenz mit einer ersten Datenart erzeugt wird, die eine Bibliothek erster Symbole mit einer ersten Codelänge umfasst, beinhaltend, wobei die zweite Codelänge kürzer als die erste Codelänge ist, wobei das Decodieren ein Ausgabesymbol mit der ersten Datenart erzeugt, wobei das computerimplementierte Verfahren Folgendes umfasst:

Empfangen des m. Symbols aus der zweiten Datensequenz;
Erzeugen des Ausgabesymbols unter Verwendung einer Transformation, die zu einem festgelegten Satz von Transformationen gehört, welche die zweite Datenart in die erste Datenart abbilden; wobei der festgelegte Satz von Transformationen mehrere Teilmengen von Transformationen umfasst, wobei jede Teilmenge von Transformationen die zweite Datenart in die erste Datenart abbildet; und
das Verfahren **dadurch gekennzeichnet ist, dass** die Transformation, die zum Erzeugen des Ausgabesymbols verwendet wird, ein Element einer Teilmenge von Transformationen ist, das auf der Grundlage eines Ausgabesymbols ausgewählt wird, das dem m-1. Symbol entspricht.

9. Computerimplementiertes Verfahren nach Anspruch 8, wobei jede Teilmenge des festgelegten Satzes von Transformationen einer Teilmenge festgelegter Transformationen entspricht, die während des Codierens der zweiten Datensequenz verwendbar sind.

10. Computerimplementiertes Verfahren nach Anspruch 8 oder 9, wobei jede Teilmenge des festgelegten Satzes von Transformationen Folgendes beinhaltet:
eine Gruppe von Transformationen, welche die direkten Umkehrungen einer entsprechenden Gruppe verlustloser Transformationen sind, die verwendet werden können, um die erste Datensequenz in die zweite Datensequenz zu codieren, und mehrere verbleibende Transformationen, die mehreren Gruppen verlustbehafteter Transformationen zwischen der ersten Datenart und der zweiten Datenart entsprechen, die verwendet werden können, um die erste Datensequenz in die zweite Datensequenz zu codieren.

**11.** Computerimplementiertes Verfahren nach einem der Ansprüche 8 bis 10, das ferner das Einstellen einer festgelegten Teilmenge von Transformationen, welche die zweite Datenart in die erste Datenart abbildet, zur Verwendung beim Decodieren des m+1. Symbols der zweiten Datensequenz beinhaltet.

**12.** Codiervorrichtung, Folgendes umfassend:

einen Eingang, an dem eine erste Datensequenz empfangen wird; wobei die erste Datensequenz erste Datensymbole einer ersten Datenart umfasst und eine erste Codelänge aufweist,

einen Ausgang, an dem eine zweite Datensequenz übertragen wird; wobei die zweite Datensequenz zweite Datensymbole einer zweiten Datenart umfasst und eine zweite Codelänge aufweist, die sich von der ersten Codelänge unterscheidet;

ein Verarbeitungssystem, das dafür konfiguriert ist, empfangene Symbole der ersten Datensequenz nacheinander zu verarbeiten und Symbole der zweiten Datensequenz auszugeben; wobei das Verarbeitungssystem dafür konfiguriert ist, ein Verfahren nach einem der Ansprüche 1 bis 7 durchzuführen.

**13.** Codiervorrichtung nach Anspruch 12, wobei die Vorrichtung ferner dafür eingerichtet ist, ein Verfahren zum Decodieren eines m. Symbols einer zweiten Datensequenz, das eine zweite Datenart aufweist und durch Codieren des n. Symbols einer ersten Datensequenz mit einer ersten Datenart erzeugt wird, durchzuführen, wobei das Decodieren ein Ausgabesymbol mit der ersten Datenart erzeugt, wobei das Verfahren Folgendes umfasst:

Empfangen des m. Symbols der zweiten Datensequenz;

Erzeugen des Ausgabesymbols unter Verwendung einer Transformation, die zu einem festgelegten Satz von Transformationen gehört, welche die zweite Datenart in die erste Datenart abbilden; wobei der festgelegte Satz von Transformationen mehrere Teilmengen von Transformationen umfasst, wobei jede Teilmenge von Transformationen die zweite Datenart in die erste Datenart abbildet; und

wobei die Transformation, die zum Erzeugen des Ausgabesymbols verwendet wird, ein Element einer Teilmenge von Transformationen ist, die auf der Grundlage eines Ausgabesymbols ausgewählt werden, das dem m-1. Symbol entspricht.

**14.** Decodiervorrichtung, Folgendes umfassend:

einen Eingang, an dem eine zweite Datensequenz empfangen wird; wobei die zweite Datensequenz zweite Datensymbole einer zweiten Datenart umfasst und eine zweite Codelänge aufweist,

einen Ausgang, an dem Ausgabesymbole übertragen werden, wobei die Ausgabesymbole eine erste Datenart aufweisen, die einer ersten Datenart einer ersten Datensequenz entspricht, die codiert wurde, um die zweite Datensequenz zu bilden;

ein Verarbeitungssystem, das dafür konfiguriert ist, empfangene Symbole der zweiten Datensequenz nacheinander zu verarbeiten und Symbole der dritten Datensequenz mit der gleichen Datenart wie die erste Datensequenz auszugeben;

wobei das Verarbeitungssystem dafür konfiguriert ist, ein Verfahren nach einem der Ansprüche 8 bis 11 durchzuführen.

## Revendications

**1.** Procédé mis en œuvre par ordinateur pour comprimer des données faisant intervenir la transformation d'un nième symbole d'une première séquence de données en un mième symbole d'une deuxième séquence de données, le procédé mis en œuvre par ordinateur comprenant :

le fait de recevoir le nième symbole de la première séquence de données ;

le fait de générer le mième symbole de la deuxième séquence de données à partir du nième symbole de la première séquence de données grâce à l'utilisation d'une transformation appartenant à un ensemble prédéterminé de transformations mettant en correspondance un premier type de données comprenant une bibliothèque de premiers symboles ayant une première longueur de code avec un deuxième type de données comprenant une bibliothèque de deuxièmes symboles ayant une deuxième longueur de code qui est plus courte que ladite première longueur de code ; ledit ensemble prédéterminé de transformations comprenant une pluralité de sous-ensembles de transformations, dans lequel chaque sous-ensemble de transformations met en correspondance le premier type de données avec le deuxième type de données, et inclut un groupe de transformations sans pertes qui mettent en correspondance sans pertes certains symboles du premier type de données avec des symboles du deuxième type de données, et au moins un groupe de transformations avec pertes entre des symboles restants du premier type de données et du deuxième type de données ;

le procédé étant **caractérisé en ce que** ladite transformation utilisée pour générer le mième symbole de la deuxième séquence de données à partir du nième symbole de la première séquence de données est un membre d'un sous-ensemble de transformations dans lequel un n-1ème symbole de la première séquence de données se trouve parmi les certains symboles qui sont mis en correspondance sans pertes avec un deuxième symbole dans ledit groupe de sous-ensembles de transformations sans pertes.

2. Procédé mis en œuvre par ordinateur de la revendication 1 dans lequel, dans chaque sous-ensemble de transformations, les certains symboles du premier type de données qui sont mis en correspondance sans pertes avec des symboles du deuxième type de données, représentent un groupe contigu de valeurs de données.

3. Procédé mis en œuvre par ordinateur de la revendication 2 dans lequel, dans chaque sous-ensemble de transformations, le groupe ou chaque groupe de symboles restants du premier type de données qui est/sont transformé/s avec une transformation avec pertes en ledit deuxième type de données représente/nt un groupe contigu de valeurs de données.

4. Procédé mis en œuvre par ordinateur de n'importe laquelle des revendications précédentes dans lequel, dans chaque sous-ensemble de transformations, le deuxième type de données comprend un premier nombre de symboles avec lequel lesdits certains symboles du premier type de données sont mis en correspondance sans pertes et un deuxième nombre de symboles avec lequel les autres symboles du premier type de données sont mis en correspondance avec pertes, dans lequel le premier nombre de symboles et le deuxième nombre de symboles dans la bibliothèque des deuxièmes données sont égaux.

5. Procédé mis en œuvre par ordinateur tel que revendiqué dans n'importe laquelle des revendications précédentes qui inclut en outre, le fait de déterminer un sous-ensemble suivant de transformations, pour une utilisation dans la transformation du n+1ième symbole de la première séquence de données, sur la base du nième symbole de la première séquence de données ; et le fait de transformer le n+1ième symbole de la première séquence de données en m+1ième symbole de la deuxième séquence de données grâce à l'utilisation d'une transformation provenant du sous-ensemble suivant de transformations.

6. Procédé mis en œuvre par ordinateur tel que revendiqué dans la revendication 5 dans lequel, dans le sous-ensemble suivant de transformations, le nième symbole est mis en correspondance sans pertes avec un symbole du deuxième type de données.

7. Procédé mis en œuvre par ordinateur de la revendication 6, le procédé incluant en outre le fait de réaliser une transformation inverse du mième symbole de la deuxième séquence de données en premier type de données grâce à l'utilisation d'une transformation inverse qui correspond à une transformation dans le même sous-ensemble de transformations utilisé pour générer le mième symbole de la deuxième séquence.

8. Procédé mis en œuvre par ordinateur pour décomprimer des données faisant intervenir le décodage d'un mième symbole d'une deuxième séquence de données ayant un deuxième type de données comprenant une bibliothèque de deuxièmes symboles ayant une deuxième longueur de code, qui a été créé grâce au codage du nième symbole d'une première séquence de données ayant un premier type de données comprenant une bibliothèque de premiers symboles ayant une première longueur de code, dans lequel la deuxième longueur de code est plus courte que la première longueur de code, ledit décodage générant un symbole de sortie ayant ledit premier type de données, le procédé mis en œuvre par ordinateur comprenant :

le fait de recevoir le mième symbole de la deuxième séquence de données ;
le fait de générer le symbole de sortie grâce à l'utilisation d'une transformation appartenant à un ensemble prédéterminé de transformations mettant en correspondance le deuxième type de données avec le premier type de données ; ledit ensemble prédéterminé de transformations comprenant une pluralité de sous-ensembles de transformations, dans lequel chaque sous-ensemble de transformations met en correspondance le deuxième type de données avec le premier type de données ; et
le procédé étant **caractérisé en ce que** ladite transformation utilisée pour générer le symbole de sortie est un membre d'un sous-ensemble de transformations sélectionné sur la base d'un symbole de sortie correspondant au m-1ième symbole.

9. Procédé mis en œuvre par ordinateur tel que revendiqué dans la revendication 8 dans lequel chaque sous-ensemble d'un ensemble prédéterminé de transformations correspond à un sous-ensemble de transformations prédéterminées qui sont aptes à être utilisées durant le codage de la deuxième séquence de données.

10. Procédé mis en œuvre par ordinateur tel que revendiqué dans la revendication 8 ou 9 dans lequel chaque sous-ensemble d'un ensemble prédéterminé de transformations inclut :
un groupe de transformations qui sont les inverses directs d'un groupe correspondant de transformations sans pertes qui peuvent être utilisées pour coder la première séquence de données en deuxième séquence de données, et une pluralité de transformations restantes qui correspondent à une pluralité de groupes de transformations avec pertes entre le premier type de données et le deuxième type de données qui peuvent être utilisées pour coder la première séquence de données en deuxième séquence de données.

11. Procédé mis en œuvre par ordinateur tel que revendiqué dans n'importe laquelle des revendications 8 à 10 qui inclut en outre la définition d'un sous-ensemble prédéterminé de transformations mettant en correspondance le deuxième type de données avec le premier type de données pour une utilisation dans le décodage du m+1ième symbole de la deuxième séquence de données.

12. Dispositif de codage comprenant :

une entrée sur laquelle une première séquence de données est reçue ; ladite première séquence de données comprenant des premiers symboles de données d'un premier type de données et ayant une première longueur de code,
une sortie sur laquelle une deuxième séquence de données est transmise ; ladite deuxième séquence de données comprenant des deuxièmes symboles de données d'un deuxième type de données et ayant une deuxième longueur de code qui est différente de ladite première longueur de code ;
un système de traitement configuré pour traiter des symboles reçus de la première séquence de données en série et des symboles de sortie de la deuxième séquence de données ; dans lequel le système de traitement est configuré pour réaliser un procédé tel que revendiqué dans n'importe laquelle des revendications 1 à 7.

13. Dispositif de codage tel que revendiqué dans la revendication 12, le dispositif étant conçu en outre pour réaliser un procédé de décodage d'un mième symbole d'une deuxième séquence de données ayant un deuxième type de données et étant créé grâce au codage du nième symbole d'une première séquence de données ayant un premier type de données, ledit décodage générant un symbole de sortie ayant ledit premier type de données, le procédé comprenant :

le fait de recevoir le mième symbole de la deuxième séquence de données ;
le fait de générer le symbole de sortie grâce à l'utilisation d'une transformation appartenant à un ensemble prédéterminé de transformations mettant en correspondance le deuxième type de données avec le premier type de données ; ledit ensemble prédéterminé de transformations comprenant une pluralité de sous-ensembles de transformations, dans lequel chaque sous-ensemble de transformations met en correspondance le deuxième type de données avec le premier type de données ; et
dans lequel ladite transformation utilisée pour générer le symbole de sortie est un membre d'un sous-ensemble de transformations sélectionné sur la base d'un symbole de sortie qui correspond au m-1ième symbole.

14. Dispositif de décodage comprenant :

une entrée sur laquelle une deuxième séquence de données est reçue ; ladite deuxième séquence de données comprenant des deuxièmes symboles de données d'un deuxième type de données et ayant une deuxième longueur de code,
une sortie sur laquelle des symboles de sortie sont transmis, lesdits symboles de sortie ayant un premier type de données correspondant à un premier type de données d'une première séquence de données qui avait été codée pour former la deuxième séquence de données ;
un système de traitement configuré pour traiter des symboles reçus de la deuxième séquence de données en série et des symboles de sortie de la troisième séquence de données avec le même type de données que la première séquence de données ;
dans lequel le système de traitement est configuré pour réaliser un procédé tel que revendiqué dans n'importe laquelle des revendications 8 à 11.

FIG. 1

FIG. 2

FIG. 2 A

FIG. 3

300

300.0

300.1

300.2

300.3

300.4

300.5

300.6

300.7

300.8

FIG. 3A

Subset of
transformations
402

Receive nth symbol
404

Encode nth symbol
406

Output mth symbol
408

# FIG. 4A

Config (from input parameters)
**409**

Choose first code table
**410**

Receive first symbol
**412**

Encode 1st symbol
**414**

Output 1st symbol
**415**

Subset of transformations
**402**

Receive nth symbol
**404**

Encode nth symbol
**406**

Output mth symbol
**408**

Finished
**420**

# FIG. 4B

**FIG. 5A**

Config (from input parameters)
**509**

Choose first code table
**510**

Receive first symbol
**512**

Decode 1st symbol
**514**

Output 1st symbol
**515**

Subset of transformations
**502**

Receive mth symbol
**504**

Decode mth symbol
**506**

Output n*th symbol
**508**

Finished
**520**

# FIG. 5B

FIG. 6

EncodeSample
**500**

calc lossless_low
**501**

calc lossless_high
**502**

lossless?
**503**

Y

Return lossless
**504**

N

low?
**505**

Y

Return low
**506**

N

Return high
**507**

# FIG. 7

FIG. 8

**FIG. 9**

EncodeSequence
**700**

initialise
**701**

Samples
**703**

Input sample
**702**

EncodeSample
**704**

Output codeword
**705**

Codewords
**706**

DecodeSample
**707**

NextTable
**708**

Y   N

last?
**709**

Done
**710**

FIG. 10

FIG. 11

Encoder 102

PCB

FPGA 204

PHY 205

10GbE 206

SDI IN 201

DC IN 202

PSU 203

EP 4 633 043 B1

44

**FIG. 12**

# FIG. 13

FIG. 14A

FIG. 14B

FIG. 15A

FIG. 15B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **KULDIP K. ADE et al.** ROI based near lossless hybrid image compression technique. *ICECCT*, 2015